# EUROPÄISCHE PATENTSCHRIFT

(11) **EP 2 100 330 B1**
(45) Veröffentlichungstag und Bekanntmachung des Hinweises auf die Patenterteilung: **07.03.2012**
(21) Anmeldenummer: 07847998.7
(22) Anmeldetag: 07.12.2007
(51) Int. Cl.: H01L 21/8228, H01L 21/8249, H01L 27/06, H01L 27/082

(54) **KOMPLEMENTÄRE BIPOLAR-HALBLEITERVORRICHTUNG UND HERSTELLUNGSVERFAHREN**
COMPLEMENTARY BIPOLAR SEMICONDUCTOR DEVICE AND METHOD OF MANUFACTURING
DISPOSITIF SEMI-CONDUCTEUR BIPOLAIRE COMPLEMENTAIRE ET METHODE DE FABRICATION

(30) Priorität: 08.12.2006 DE 102006059113
(43) Veröffentlichungstag der Anmeldung: 16.09.2009
(73) Patentinhaber: IHP GmbH-Innovations for High Performance Microelectronics / Leibniz-Institut für innovative Mikroelektronik, 15236 Frankfurt / Oder (DE)
(72) Erfinder: KNOLL, Dieter, 15230 Frankfurt (Oder) (DE); HEINEMANN, Bernd, 15234 Frankfurt (Oder) (DE); EHWALD, Karl-Ernst, 15234 Frankfurt (Oder) (DE)
(74) Vertreter: Eisenführ, Speiser & Partner
(86) Internationale Anmeldenummer: PCT/EP2007/063551
(87) Internationale Veröffentlichungsnummer: WO 2008/068340

(56) Entgegenhaltungen:
- WO-A-03/036724
- JP-A- 11 017 039
- US-A1- 2003 020 166
- US-A1- 2003 146 468
- US-B1- 6 169 007

## Beschreibung

Die Erfindung betrifft eine komplementäre Bipolar-Halbleitervorrichtung, nachfolgend auch CBi-Halbleitervorrichtung genannt, wie in Anspruch 1 offenbart.

Weiterhin betrifft die Erfindung ein Verfahren zur Herstellung einer solchen komplementären Bipolar-Halbleitervorrichtung, wie in Anspruch 10 offenbart. Aus schaltungstechnischen Gründen ist es oft vorteilhaft, auf einem monolithischen Halbleiter-Chip gleichzeitig über komplementäre Bipolartransistoren und komplementäre Metall-Oxid-Halbleiter (engl.: Complementary Metal Oxide Semiconductor, CMOS)-Transistoren zu verfügen. Eine Technologie, die die Fertigung genau dieses Transistorspektrums zum Ziel hat, wird als komplementäre Bipolar-CMOS (engl.: Complementary Bipolar CMOS Technology, CBiCMOS)-Technologie oder CBiCMOS-Prozess bezeichnet, während die kombinierte Herstellung nur eines Bipolartransistortypes, üblicherweise eines npn-Bipolartransistors, gemeinsam mit CMOS-Transistoren als BiCMOS-Technologie oder BiCMOS-Prozess bezeichnet wird.

Üblicherweise werden Bipolartransistoren in CBiCMOS- oder BiCMOS-Chips, nachfolgend auch gemischte Chips genannt, in Schaltungsteilen eingesetzt, wo ihre in vielerlei Hinsicht bessere Hochfrequenz-Leistungsfähigkeit im Vergleich zu CMOS-Transistoren von Nutzen ist. Die CMOS-Transistoren werden in gemischten Chips oft, wie in reinen CMOS-Chips, hauptsächlich in Schaltungsblöcken eingesetzt, die der digitalen Signalverarbeitung dienen.

Durch diese typische Aufgabenteilung zwischen Bipolar- und CMOS-Transistoren enthalten gemischte Chips meist ungleich mehr CMOS-Transistoren (typischerweise mehrere Millionen) als Bipolartransistoren (typischerweise einige Tausend bis Zehntausend). Vor allem dieses "Ungleichgewichtes" wegen ist es übliche Praxis, bei der Entwicklung von BiCMOS- und CBiCMOS-Technologien von einem vorhandenen CMOS-Grundprozess auszugehen, in den nachträglich die technologischen Schritte für die Herstellung der Bipolarkomponenten integriert werden. Dieser Integrationsprozess sollte dabei im Idealfall folgende Merkmale aufweisen:
a) Modulare Bipolarintegration: So genannte CMOS-Bibliotheken (engl.: CMOS libraries), kleine "Elementarschaltungen" des CMOS-Grundprozesses, die effektiv zum Entwurf komplexer digitaler Schaltungsblöcke benutzt werden können, müssen auch im abgeleiteten BiCMOS- oder CBiCMOS-Prozess funktionieren. Das erfordert, dass die Bipolar-Integration die CMOS-Transistor-Eigenschaften im Vergleich zum Grundprozess nicht über ein tolerables, meist äußerst geringes Maß hinaus verändert.
b) Kostengünstige Bipolarintegration: Die Integration der Bipolarkomponenten soll in einer Art und Weise erfolgen, die so wenig wie möglich zusätzliche Prozessschritte, vor allem auch lithografische Schritte, zum CMOS-Grundprozess hinzufügt.
c) Höchstleistungs-Bipolarintegration: Die Bipolartransistoren sollen in mehreren Varianten, meist gekennzeichnet durch verschiedene Kombinationen von Kollektor-Emitter-Durchbruchsspannung, gemessen mit offenem Basisanschluss (BVCEO) und maximaler Transitfrequenz (fT), im BiCMOS- bzw. CBiCMOS-Prozess verfügbar sein und dabei möglichst Hochfrequenz-Eigenschaften aufweisen, die denen sehr nahe kommen, die in reiner Bipolartechnologie, das heißt insbesondere auch ohne Rücksicht auf a) und b), im besten Fall realisierbar wären.

Es ist leicht vorstellbar, dass es eine sehr große Herausforderung bei der Entwicklung von BiCMOS- aber insbesondere von CBiCMOS-Technologien darstellt, Merkmal c) mit den Merkmalen a) und b) einigermaßen in Übereinklang zu bringen.

Die Hochfrequenz-Leistungsfähigkeit von Bipolartransistoren (engl.: Bipolar Junction Transistor, BJT) auf Siliziumbasis ist in den letzten Jahren durch die Verwendung einer Hetero-Basisschicht, die mittels Epitaxie hergestellt wird, wesentlich verbessert worden. Die Hetero-Basisschicht besteht dabei aus einer Mischung von Silizium und Germanium (SiGe), wobei der Ge-Anteil oft bewusst innerhalb der Schicht längs ihrer Wachstumsrichtung variiert wird. Transistoren mit solch einer Basisschicht werden als SiGe-HBTs (engl.: Heterojunction Bipolar Transistor, HBT) bezeichnet.

Außerdem ist ein weiterer Leistungsschub bei SiGe-HBTs durch den zusätzlichen Einbau von Kohlenstoff in die SiGe-Basisschicht und/oder in angrenzende

Siliziumgebiete ausgelöst worden. SiGe-HBTs mit zusätzlichem Kohlenstoffeinbau werden nachfolgend als SiGe:C-HBTs bezeichnet. Diese Entwicklungen bezogen sich zunächst hauptsächlich auf npn-Transistoren, wobei in letzter Zeit mit den gleichen Maßnahmen auch die Hochfrequenz-Leistungsfähigkeit von pnp-Transistoren drastisch verbessert werden konnte.

Dem heutigen Stand der Technik entsprechende Gestaltungsmerkmale von komplementären Bipolartransistoren und Verfahrensschritte einer CBiCMOS-Technologie mit npn-SiGe-HBTs und pnp-SiGe-HBTs sind in B. EI-Kareh, S. Balster, W. Leitz, P. Steinmann, H. Yasuda, M. Corsi, K. Dawoodi, C. Dirnecker, P. Foglietti, A. Haesler, P. Menz, M. Ramin, T. Scharnagl, M. Schiekofer, M. Schober, U. Schutz, L. Swanson, D. Tatman, M. Waitschull, J. W. Weijtmans und C. Willis: "A 5V complementary-SiGe BiCMOS technology for high-speed precision analog circuits", BCTM, pp. 211-214, 2003, veröffentlicht (nachfolgend EI-Kareh et al.). Die dort beschriebene Lösung zielt auf möglichst geringe parasitäre Kapazitäten und einen möglichst geringen Kollektorwiderstand. Kleine Kollektor-Substratkapazitäten werden mit Hilfe tiefer, mit Isolatormaterial verfüllter Gräben (engl.: "deep trenches") sowie mit einer vergrabenen Siliziumoxidschicht in SOI-Technologie (engl.: "silicon on isolator") realisiert. Außerdem sichert die vergrabene Oxidschicht in Verbindung mit den tiefen Gräben die elektrische Isolation der Kollektoren gegen das Substrat. Um die Kollektorwiderstände klein zu halten, werden bei El-Kareh et al. epitaktisch vergrabene, hochdotierte Kollektorschichten sowie spezielle Implantationsschritte für einen niederohmigen Anschluss der vergrabenen Kollektorschichten, so genannte "collector sinker", verwendet. EI-Kareh et al. erreichen mit dieser CBiCMOS-Technologie Grenzfrequenzen fT (Transitfrequenz) / fmax (maximale Schwing-frequenz) von 19/60 GHz für npn-Transistoren und 19/45 GHz für pnp-Transistoren. Das Dokument US20031 0146468 offenbart komplementäre Bipolartransistoren mit tiefen gräben. Nachteil dieses Verfahrens ist jedoch, dass typische moderne CMOS-Technologien weder epitaktisch vergrabene Kollektorschichten noch tiefe Isolationsgräben noch Collector Sinker enthalten. Der zusätzliche Prozessaufwand zur Realisierung dieser Strukturen ist zum Teil erheblich. Da die CMOS-Transistoren in die Epitaxieschicht, die über den dadurch vergrabenen Kollektorschichten abgeschieden wird, eingebracht werden, ist eine zusätzliche Wärmebelastung der von EI-Kareh et al. verwendeten vergrabenen Kollektorschichten während des CMOS-Prozesses nicht zu vermeiden. Dies verringert die Profilsteilheit der vergrabenen Kollektorschichten, wodurch die Leistungsfähigkeit beider Bipolartransistortypen, insbesondere jedoch die der pnp-Transistoren im Hochgeschwindigkeitsbereich beeinträchtigt wird.

Weiterhin hat das von EI-Kareh et al. beschriebene Verfahren den Nachteil, dass Prozessschritte für CMOS- und Bipolarbauelemente in einer Art gekoppelt werden, die eine echte Modularität der Bipolar-Integration behindert. So wird als Gate-Elektrode ein Schichtstapel benutzt, der aus zwei Abscheideprozessen resultiert, und nicht, wie üblich in CMOS-Prozessen, eine einzelne polykristalline Siliziumschicht (Polysiliziumschicht). Der Gate-Stapel besteht bei EI-Kareh et al. aus einer Polysiliziumschicht und einer p-dotierten polykristallinen SiGe-Schicht, die während der Abscheidung der Basis der npn-Bipolartransistoren entsteht. Durch diese Kopplung wird das Ziel verfolgt, den Prozessaufwand und somit die Komplexität und Kosten der vorgeschlagenen CBiCMOS-Technologie gering zu halten. Der Nachteil dieses Verfahrens ist jedoch, dass auf diese Weise die üblicherweise angestrebte Austauschbarkeit von Prozessmodulen behindert wird.

Wie oben bereits erwähnt, bietet weiterhin zwar die Verwendung eines SOI-Substrates in Kombination mit "deep trenches" den Vorteil, ohne weitere technologische Aufwendungen eine elektrische Isolation der Bipolartransistoren zu ermöglichen. Außerdem kann die Kollektor-Substrat-Kapazität vergleichsweise klein gehalten werden. SOI-Substrate haben jedoch insbesondere den Nachteil, dass die Abführung der beim Transistorbetrieb entstehenden Wärme im Vergleich zu Standardsubstraten erheblich erschwert ist. Dieser Nachteil bewirkt eine zusätzliche Selbstaufheizung der Transistoren unter den Betriebsbedingungen im Hochgeschwindigkeitsbereich und führt damit zu einer Verringerung des Leistungspotentials.

Ferner sind die in El-Kareh et al. vorhandenen Siliziumschichten auf der vergrabenen Oxidschicht des SOI-Substrates in der vertikalen Ausdehnung zu mächtig, um ohne Schwierigkeiten optimierte MOS-Transistoren, z.B. sogenannte "fully depleted MOS-Transistoren", auf SOI-Substrat herstellen zu können. Die Integration der komplementären Bipolartransistoren mit einer CMOS-Technologie, die für Standard-Substrate entwickelt wurde, erfordert allein wegen des Übergangs auf SOI-Substrat zusätzliche Aufwendungen.

Viele der diskutierten Nachteile des von EI-Kareh et al. beschriebenen CBiCMOS-Prozesses und der darin enthaltenen Gestaltungsmerkmale der komplementären Bipolartransistoren werden in einem CBiCMOS-Prozess mit komplementären SiGe:C-HBTs vermieden, der von B. Heinemann, R. Barth, D. Bolze, J. Drews, P. Formanek, O. Fursenko, M. Glante, K. Glowatzki, A. Gregor, U. Haak, W. Höppner, D. Knoll, R. Kurps, S. Marschmeyer, S. Orlowski, H. Rücker, P. Schley, D. Schmidt, R. Scholz, W. Winkler und Y. Yamamoto: "A complementary BiCMOS technology with high speed npn and pnp SiGe:C HBTs", IEDM, pp. 117-120, 2003, beschrieben wurde (nachfolgend Heinemann et al.). So nutzt dieser CBiCMOS-Prozess Standard-Substrate und benötigt keine "deep trenches" für niedrige Kollektor-Substrat-Kapazitäten. Die Integration der komplementären Bipolartransistoren, einschließlich deren Kollektor-Implantation, erfolgt erst nach Strukturierung der Standard-CMOS-Gates, was eine wirklich modulare Bipolarintegration ermöglicht. Heinemann et al. erreichen mit dieser CBiCMOS-Technologie Grenzfrequenzen fT/fmax von 180/185 GHz bei einer Durchbruchsspannung BVCEO von 2V für npn-Transistoren und 80/120 GHz bei BVCEO von 2.6V für pnp-Transistoren.

Die ausgezeichneten Hochfrequenz-Eigenschaften der komplementären Bipolartransistoren von Heinemann et al., hergestellt in einem bipolaren Prozessablauf, der ohne Probleme modular in einen typischen, hoch skalierten CMOS-Grundprozess integriert werden kann, resultieren im wesentlichen aus zwei Merkmalen, der Verwendung einer neuartigen Kollektorkonstruktion und der erstmaligen Verwendung einer SiGe:C-Basisschicht auch für die pnp-Transistoren. Beide Merkmale werden nachfolgend kurz erläutert.

Die neuartige, von Heinemann et al. beschriebene Kollektorkonstruktion, die sowohl für die npn- als auch pnp-Transistoren (mit entsprechender Dotierungsinversion) genutzt wird, besteht aus einem einheitlichen aktiven, das heißt nicht durch Isolationsgräben unterbrochenem Gebiet, welches am Außenrand lediglich durch flache, mit Siliziumoxid verfüllte Gräben begrenzt wird. Solche flache Gräben (engl.: "shallow trenches") weisen im Unterschied zu den vorher diskutierten "deep trenches" Tiefen von deutlich weniger als 1 µm, typischerweise 0.5 µm auf. "Shallow trenches" sind üblicher Bestandteil jeder modernen CMOS-Technologie, so dass deren Nutzung im Bipolarmodul einer BiCMOS- oder CBiCMOS-Technologie ohne jeglichen Zusatzaufwand und damit Kosten möglich ist. In das einheitliche aktive Gebiet wird der Kollektorimplant (oder eine Folge von Kollektor-Implanten) in einer Weise eingebracht und ausgeheilt, dass sich der np-Übergang zum p-Substrat (für den npn-Transistor) und/oder der pn-Übergang zu einer n-implantierten Isolationsschicht (für den pnp-Transistor) nicht tiefer befindet als der Boden der "shallow trenches", die das einheitliche aktive Gebiet außen begrenzen. Auf diese Weise wird zunächst gewährleistet, dass niedrige Kollektor-Substrat-Kapazitäten auch ohne die Benutzung einer aufwendigen "Deep Trench Isolation" erreicht werden.

Da oberhalb des einheitlichen aktiven Kollektorgebietes die sogenannte innere Basis des Transistors und darüber der Emitter gebildet werden und dann Emitter und Kollektor innerhalb der Draufsicht auf das einheitliche Kollektorgebiet kontaktiert werden, gelingt es auch, sehr niedrige Kollektorwiderstände ohne Verwendung epitaktisch vergrabener, hoch dotierter Kollektorschichten und spezieller "Collector Sinker" zu erreichen.

Das zweite Hauptmerkmal der von Heinemann et al. beschriebenen CBiMOS-Technologie besteht in der erstmaligen Verwendung einer SiGe:C-Basisschicht auch für den pnp-Transistor und der Einbringung eines speziellen n-Dotierungsprofiles während des Basis-Abscheideprozesses für diesen Transistortyp. Damit werden bestimmte Nachteile des Si/SiGe Heteroübergangs für pnp-Transistoren vermieden, vgl. D. V. Singh, J. L. Hoyt, J. F. Gibbons: "Effect of band alignment and density of states on the collector current in p-Si/n-Si1-yCy/p-Si HBTs", IEDM, pp. 749-752, 2000, und eine verbesserte Stabilität gegen die Diffusion von Dotierelementen erhalten, ähnlich wie im npn-Fall. Das kommt den Hochfrequenz-Eigenschaften der pnp-Transistoren und vor allem deren "Aufrechterhaltung" innerhalb einer CMOS-Umgebung mit den dort üblicherweise angewandten Ausheilprozessen für die Source/Drain-Implante, die in einem BiCMOS- oder CBiCMOS-Prozess auch auf die Basisdotierprofile der Bipolartransistoren einwirken können, außerordentlich zugute.

Zusammenfassend kann man einschätzen, dass der CBiCMOS-Prozess von Heinemann et al. bereits zwei der eingangs genannten Merkmale einer "idealen" Integration von Bipolarkomponenten, insbesondere von komplementären Bipolarkomponenten, in einen CMOS-Grundprozess aufweist, nämlich die Merkmale "Modulare Bipolarintegration" und "Höchstleistungs-Bipolarintegration". Das dritte angestrebte Merkmal, "Kostengünstige Bipolarintegration", wird jedoch im CBiCMOS-Prozess von Heinemann et al. noch nicht wirklich erreicht. Gegenüber dem CMOS-Grundprozeß werden 10 zusätzliche, der Bipolarintegration zugeordneten Maskenschritte benötigt.

Das der Erfindung zugrunde liegende technische Problem ist es daher, eine komplementäre Bipolar-Halbleitervorrichtung der eingangs genannten Art anzugeben, die kostengünstig herstellbar ist und bei der beide Bipolartransistortypen sehr gute Eigenschaften für Hochgeschwindigkeitsanwendungen aufweisen.

Ein weiteres, der Erfindung zugrunde liegendes technisches Problem ist es, ein kostengünstiges Verfahren zur Herstellung einer Bipolar-Halbleitervorrichtung anzugeben, welches ermöglicht, beide Bipolartransistortypen mit sehr guten Eigenschaften für Hochgeschwindigkeitsanwendungen herzustellen.

Gemäß einem ersten Aspekt der Erfindung wird das technische Problem gelöst durch eine komplementäre Bipolar-Halbleitervorrichtung, nachfolgend CBi-Halbleitervorrichtung, wie im Anspruch 1 offenbart.

Bei der erfindungsgemäßen CBi-Halbleitervorrichtung ist zwischen der ersten oder der zweiten oder sowohl der ersten als auch der zweiten Teilanzahl aktiver Bipolartransistorgebiete einerseits und den angrenzenden Kollektorkontaktgebieten andererseits jeweils ein flaches Feldisolationsgebiet eines ersten Typs mit einer ersten Tiefenausdehnung in Richtung des Substratinneren angeordnet. Flache Feldisolationsgebiete eines zweiten Typs mit einer zweiten, größeren Tiefenausdehnung als die erste Tiefenausdehnung begrenzen die aktiven Bipolartransistorgebiete und die Kollektorkontaktgebiete im Querschnitt gesehen an ihren von einander abgewandten Seiten.

In der erfindungsgemäßen CBi-Halbleitervorrichtung enthält mindestens einer der beiden Bipolartransistortypen flache Feldisolationsgebiete des ersten Typs. Durch die unterschiedlichen flachen Feldisolationsgebiete wird bewirkt, zwei für die Hochfrequenzeigenschaften wichtige Parameter, nämlich Kollektorwiderstand und Basis-Kollektorkapazität, gleichzeitig niedrig zu halten. Dabei werden nicht mehr als drei bis höchstens fünf zusätzliche lithografische Maskenschritte, im Vergleich zum CMOS-Grundprozess, zur Herstellung der Vorrichtung benötigt. Auf diese Weise wird eine kostengünstige Bipolarintegration erreicht.

Nachfolgend werden zunächst einige zur Beschreibung der komplementären Bipolar-Halbleitervorrichtung verwendete Begriffe näher erläutert.

Ein aktives Bipolartransistorgebiet ist ein Spezialfall eines aktiven Gebietes. Unter einem aktiven Gebiet wird allgemein ein sich im Querschnittsprofil zwischen zwei benachbarten Feldisolationsgebieten erstreckender halbleitender Substratbereich verstanden, in dem funktionelle Strukturelemente der CBi-Halbleitervorrichtung angeordnet sind. Als Beispiel zur Unterscheidung der beiden Begriffe "aktives Bipolartransistorgebiet" und "aktives Gebiet" sei auf das Beispiel des Kollektorkontaktgebietes der erfindungsgemäßen CBi-Halbleitervorrichtung hingewiesen. Dieses Gebiet ist ein aktives Gebiet aber kein aktives Bipolartransistorgebiet, weil es nicht Basis, Emitter und Kollektor des betreffenden Bipolartransistors enthält.

Nachfolgend werden Ausführungsbeispiele der erfindungsgemäßen CBi-Halbleitervorrichtung beschrieben.

Der in der CMOS-Technologie übliche Begriff des flachen Feldisolationsgebietes ist in einem Ausführungsbeispiel als ein grabenförmiges Isolationsgebiet zu verstehen, das zumindest annähernd bündig mit der Substratoberfläche abschließt und in Richtung des Substratinneren eine Tiefenausdehnung von typischerweise 300 bis 600 nm hat. Flache Feldisolationsgebiete werden typischerweise seit Einführung der 0,25 µm-CMOS-Technologie mit der so genannten "Shallow-Trench"-Technologie hergestellt. Die Gräben der flachen Feldisolationsgebiete können üblicherweise mit Siliziumdioxid oder mit einer Kombination mehrerer Isolatormaterialien verfüllt sein. Die flachen Feldisolationsgebiete des ersten Typs haben in Richtung des Substratinneren vorzugsweise eine Tiefenausdehnung zwischen 50 und 200 nm. Besonders gute Eigenschaften der CBi-Halbleitervorrichtung wurden mit Tiefenausdehnungen zwischen 70 und 150 nm erzielt.

In einem Ausführungsbeispiel haben die pnp-Bipolartransistoren und die npn-Bipolartransistoren äußere Basisgebiete, die sich nur in ihrem Leitfähigkeitstyp, nicht aber, abgesehen von ihrer Leitfähigkeitsdotierung, in ihrer Materialzusammensetzung und Dicke unterscheiden. Als äußeres Basisgebiet wird das Gebiet verstanden, das die im aktiven Bipolartransistorgebiet befindliche, so genannte innere Basis mit dem Basiskontakt bzw. den Basiskontakten verbindet. Unter Basiskontakt wird ein mit Metall gefülltes Loch in jener Isolationsschicht bezeichnet, die das äußere Basisgebiet von darüber angeordneten Metallstreifen trennt. Diese Metallstreifen dienen der Einbindung der CBi-Halbleitervorrichtung in eine integrierte Schaltung. Analoge Erklärungen gelten auch für den Emitter- bzw. den Kollektorkontakt.

In einer anderen Ausführungsform enthält die CBi-Halbleitervorrichtung zusätzlich CMOS-Transistoren. Die äußeren Basisgebiete sind aus derselben Materialschicht gebildet, aus welcher Gates der CMOS-Transistoren gebildet sind.

In einem weiteren Ausführungsbeispiel weist die CBi-Halbleitervorrichtung npn- und pnp-Bipolartransistoren mit einem in einem Emitterfenster ausgebildeten Emitter auf. Der Emitter hat Emittergebiete, die lateral und in Richtungen senkrecht zu einer Kante des Emitterfensters das Emitterfenster um einen Längenbetrag überragen. Als Emitterfenster wird jenes Gebiet bezeichnet, wo eine hochdotierte (typischerweise mit einer Dotierung von mehr als 1 × 10¹⁹ cm⁻³) Emitterschicht Kontakt zu den darunter angeordneten Teilen des aktiven Bipolartransistorgebietes hat. Das Emitterfenster ist lateral von isolierendem Material umgeben.

Der Längenbetrag, um den die Emittergebiete das Emitterfenster überragen, ist vorzugsweise bezüglich jedem Punkt der Fensterkante gleich. Die Emittergebiete können das Emitterfenster bei den npn-Bipolartransistoren in unterschiedlichen Ausführungsbeispielen um entweder den gleichen oder um einen anderen Längenbetrag überragen als bei den pnp-Bipolartransistoren. Der Längenbetrag hat bei den npn-Bipolartransistoren und bei den pnp-Bipolartransistoren vorzugsweise einen jeweiligen Wert zwischen 30 und 80 nm.

In einem weiteren Ausführungsbeispiel ist ausschließlich bei demjenigen Bipolartransistortyp, bei dem der Leitfähigkeitstyp des Substrates mit dem des Kollektorgebietes übereinstimmt, zwischen Kollektor und Substrat ein Isolationsdotierungsgebiet angeordnet, welches ausgebildet ist, Kollektor und Substrat von einander elektrisch zu isolieren.

Gemäß einem zweiten Aspekt der Erfindung wird ein Verfahren zur Herstellung einer CBi-Halbleitervorrichtung angegeben. Das verfahren hat die Schritte wie im Anspruch 10 offenbart.

Das Herstellen der flachen Feldisolationsgebiete umfasst das Herstellen jeweils eines flachen Feldisolationsgebietes eines ersten Typs mit einer ersten Tiefenausdehnung in Richtung des Substratinneren zwischen der ersten oder der zweiten oder sowohl der ersten als auch der zweiten Teilanzahl aktiver Bipolartransistorgebiete einerseits und den angrenzenden Kollektorkontaktgebieten andererseits. Das Herstellen der flachen Feldisolationsgebiete umfasst das Herstellen flacher Feldisolationsgebiete eines zweiten Typs mit einer zweiten, größeren Tiefenausdehnung als die erste Tiefenausdehnung, die die aktiven Bipolartransistorgebiete und die Kollektorkontaktgebiete im Querschnitt gesehen an ihren von einander abgewandten Seiten begrenzen.

Das Herstellungsverfahren des zweiten Aspekts der Erfindung teilt die oben beschriebenen Vorteile der CBi-Halbleitervorrichtung des ersten Aspekts der Erfindung.

Es wird angemerkt, dass die oben zur Beschreibung des erfindungsgemäßen Verfahrens verwendete Reihenfolge von Schritten nicht der Reihenfolge der Durchführung der Schritte entsprechen muss. Das Herstellen der flachen Feldisolationsgebiete erfolgt beispielsweise in einem Ausführungsbeispiel vor dem Herstellen der aktiven Bipolartransistortgebiete und der Kollektorkontaktgebiete.

Weiterhin wird angemerkt, dass das Herstellen aktiver Bipolartransistorgebiete im Substrat zum späteren Herstellen von Basis, Emitter und Kollektor vertikaler Bipolartransistoren darin sich auf die laterale Anordnung von Basis, Emitter und Kollektor relativ zum jeweiligen Bipolartransistorgebiet angibt. Der Schritt ist nicht etwa so zu verstehen, dass Basis oder Emitter im Substratinneren anzuordnen wären.

Nachfolgend werden Ausführungsbeispiele des erfindungsgemäßen Verfahrens beschrieben. bei das Herstellen der pnp-Bipolartransistoren und der npn-Bipolartransistoren das Herstellen äußerer Basisgebiete umfasst, die sich nur in ihrem Leitfähigkeitstyp, nicht aber, abgesehen von ihrer Leitfähigkeitsdotierung, in ihrer Materialzusammensetzung und Dicke unterscheiden.

Bei einem Ausführungsbeispiel werden zusätzlich CMOS-Transistoren hergestellt. Äußere Basisgebiete der Bipolartransistoren werden in diesem Ausführungsbeispiel aus derselben Materialschicht gebildet, aus welcher Gates der CMOS-Transistoren gebildet werden.

Bei einem anderen Ausführungsbeispiel wird ausschließlich bei demjenigen Bipolartransistortyp, bei dem der Leitfähigkeitstyp des Substrates mit dem des Kollektorgebietes übereinstimmt, zwischen Kollektor und Substrat ein Isolationsdotierungsgebiet hergestellt, welches ausgebildet ist, Kollektor und Substrat von einander elektrisch zu isolieren.

Wie auch im Zusammenhang mit dem Vorrichtungsaspekt der Erfindung erläutert werden, die flachen Feldisolationsgebiete des zweiten Typs in Richtung des Substratinneren vorzugsweise mit einer Tiefenausdehnung zwischen 300 und 600 nm hergestellt. Die flachen Feldisolationsgebiete des ersten Typs dagegen werden vorzugsweise in Richtung des Substratinneren mit einer Tiefenausdehnung zwischen 50 und 200 nm, insbesondere zwischen 70 und 150 nm hergestellt.

Im folgenden werden die Merkmale und Vorteile der erfindungsgemäßen CBi-Halbleitervorrichtung und des erfindungsgemäßen Herstellungsverfahrens anhand weiterer Ausführungsbeispiele unter Bezugnahme auf die Figuren näher erläutert. Es zeigen:
- Fig. 1 und 2: schematische Querschnittsansichten eines Ausführungsbeispiels einer CBi-Halbleitervorrichtung in zwei unterschiedlichen Herstellungsstadien, und
- Fig. 3a bis 19: schematische Querschnittsansichten verschiedener Herstellungsphasen der CBi-Halbleitervorrichtung der Figuren 1 und 2 zur Illustration eines Ausführungsbeispiels eines Herstellungs-verfahrens.

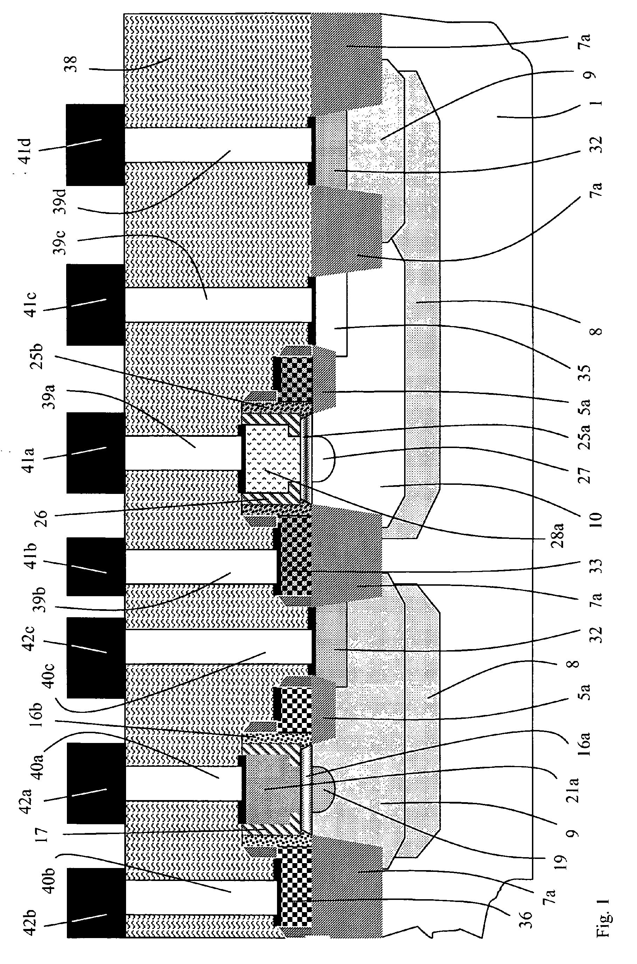

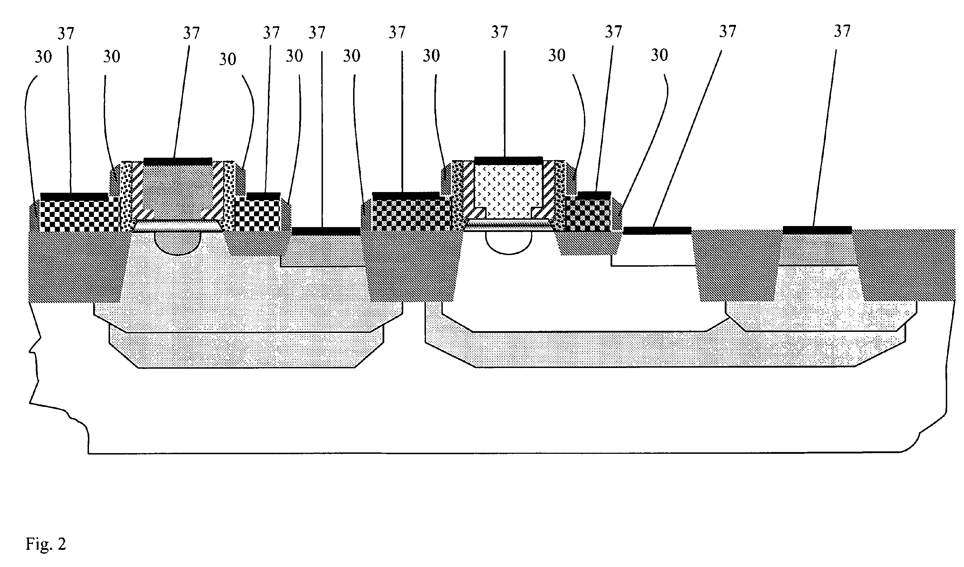

Fig. 1 und 2 illustrieren in schematischen Querschnittsansichten ein Ausführungsbeispiel einer CBi-Halbleitervorrichtung, wobei zwei Zustände der Vorrichtung in unterschiedlichen Stadien ihres Herstellungsprozesses dargestellt sind. Abbildung 1 zeigt die Vorrichtung nach erfolgter Strukturierung einer ersten Metallschicht, während Abbildung 2 einen im Herstellungsprozess vorgelagerten Zustand, nach Silizierung aller nicht mit Isolatormaterial belegten Siliziumgebiete zeigt.

Nachfolgend wird zunächst anhand der Fig. 1 und 2 ein Ausführungsbeispiel der erfindungsgemäßen CBi-Halbleitervorrichtung beschrieben.

In einem Substrat 1, wie es üblicherweise in der Siliziumtechnologie benutzt wird und das im dargestellten Fall p-leitend sein soll, befinden sich flache, mit Isolatormaterial gefüllte Gräben unterschiedlicher Tiefe. Die Gräben 7a weisen eine Tiefe auf, wie sie üblicherweise in CMOS-Technologien benutzt wird (typischerweise 300-600nm). Die Gräben 7a begrenzen lateral einerseits die aktiven Gebiete des npn-Transistors, die die n-leitenden Gebiete 8, 9 und 32 enthalten und andererseits die aktiven Gebiete des pnp-Transistors, die die p-leitenden Gebiete 10 und 35 enthalten. Die Isolation des pnp-Transistors gegen das p-leitende Substrat erfolgt durch die n-leitenden Gebiete 8 und 9, die sich unterhalb des Gebietes 10 bzw. seitlich von ihm befinden. Die Gebiete 8 und 9 bilden gemeinsam mit dem n-leitenden Gebiet 19 den Kollektor des npn-Transistors, während Gebiet 10 gemeinsam mit dem p-leitenden Gebiet 27 den Kollektor des pnp-Transistors bildet.

Ein Merkmal des vorliegenden Ausführungsbeispiels der erfindungsgemäßen Vorrichtung sind die mit dem gleichen Isolatormaterial wie die Gräben 7a gefüllten flachen Gräben 5a. Diese trennen sowohl beim npn- als auch beim pnp-Transistor lateral das aktive Bipolartransistorgebiet von den jeweiligen Kollektorkontaktgebieten (Gebiet 32 für den npn-Transistor und Gebiet 35 für den pnp-Transistor). Die Tiefe der Gräben 5a sollte im Bereich von 50 - 200 nm liegen, optimal bei 70 - 150 nm. Durch diese Gräben wird bewirkt, zwei für die Hochfrequenzeigenschaften wichtige Parameter, Kollektorwiderstand und Basis-Kollektorkapazität, gleichzeitig niedrig zu halten. Anzumerken ist, dass mindestens einer der beiden Bipolartransistortypen einen Graben 5a enthalten sollte.

Die p-leitende innere Basis der npn-Transistoren, die Bestandteil des Gebietes 16a ist, befindet sich oberhalb der n-leitenden Gebiete 9 und 19. Sie ist seitlich über die ebenfalls p-leitenden Schichten 16b und 36 mit einer Silizidschicht 37 (siehe Fig.Fig. 2) verbunden. Oberhalb des Gebietes 16a des npn-Transistors befindet sich ein hoch-n-dotiertes Gebiet 21a, das den Emitter des npn-Transistor bildet. Dieses Gebiet wird durch L-förmige Spacer 17, die aus isolierendem Material bestehen, vom p-leitenden Gebiet 16b isoliert. Die Kanten dieser Spacer auf der Oberfläche des Gebietes 16a bilden das Emitterfenster des npn-Transistors. Im vorliegenden Ausführungsbeispiel ist der Betrag, mit dem das Gebiet 21a lateral das Emitterfenster überragt, auf allen Seiten senkrecht zur Fensterkante stets gleich. Auf dem Emittergebiet 16a befindet sich wieder eine Silizidschicht 37.

Die n-leitende innere Basis der pnp-Transistoren, die Bestandteil des Gebietes 25a ist, befindet sich oberhalb der n-leitenden Gebiete 10 und 27. Sie ist seitlich über die ebenfalls n-leitenden Schichten 25b und 33 mit einer Silizidschicht 37 verbunden. Oberhalb des Gebietes 25a des pnp-Transistors befindet sich ein hoch-p-dotiertes Gebiet 28a, das den Emitter des pnp-Transistors bildet. Dieses Gebiet wird durch L-förmige Spacer 26 aus isolierendem Material vom n-leitenden Gebiet 25b isoliert. Die Kanten dieser Spacer auf der Oberfläche des Gebietes 25a bilden das Emitterfenster des pnp-Transistors. Im vorliegenden Ausführungsbeispiel ist der Betrag, mit dem das Gebiet 28a lateral das Emitterfenster überragt, auf allen Seiten senkrecht zur Fensterkante stets gleich. Er kann sich aber vom entsprechenden Betrag des npn-Transistors unterscheiden. Typische Werte für diesen Betrag liegen sowohl für den npn- als auch pnp-Transistor im Bereich von 30-80nm. Oberhalb des Emittergebietes 28a befindet sich wieder eine Silizidschicht 37.

Im vorliegenden Ausführungsbeispiel unterscheiden sich die Gebiete 33 des pnp-Transistors und 36 des npn-Transistors, die wesentliche Teile der äußeren Basisgebiete der jeweiligen Transistoren sind, für beide Bipolartransistortypen nur im Leitungstyp aber nicht in der Zusammensetzung und Dicke.

Über die Kontakte 39a - 39d, die durch eine Isolatorschicht 38 führen, sind Emitter, Basis, Kollektor und Isolationsschicht 8 des pnp-Transistors mit den Streifen 41a - 41 d einer ersten Metallschicht verbunden, mit deren Hilfe die Transistoren in integrierte Schaltungen eingebunden werden können. Die Strukturen 40a - 40b und 42a - 42b sind die entsprechenden Kontakte bzw. Metallsteifen für Emitter, Basis und Kollektor des npn-Transistors.

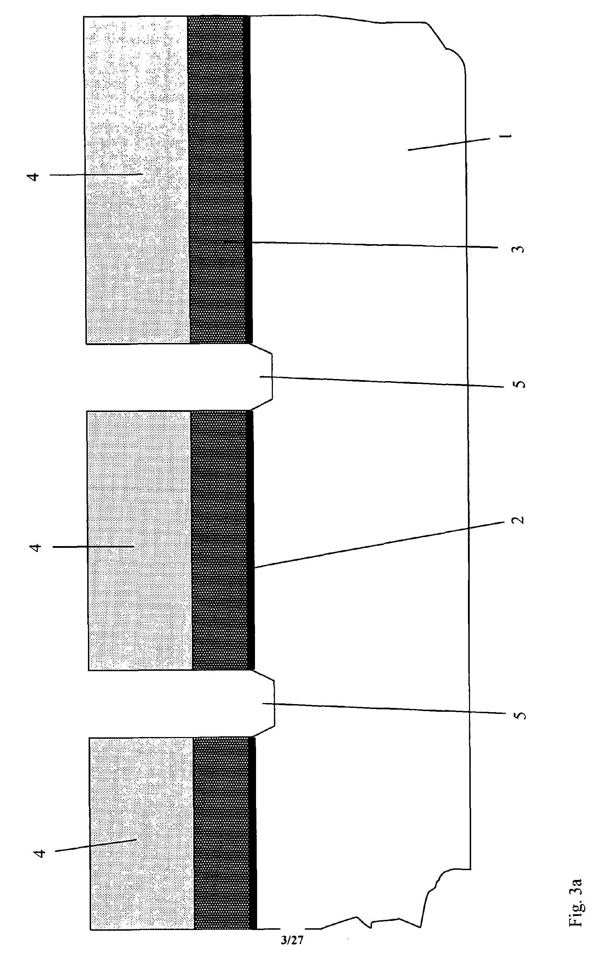

Weitere Strukturen der Vorrichtung sind die aus Isolatormaterial oder aus einer Kombination von verschiedenen Isolatormaterialien bestehenden Spacer 30 (Fig. 2), die während des Herstellungsprozesses der Vorrichtung gebildet werden. Nachfolgend wird anhand der Abbildungen 3a - 19 ein Herstellungsprozess für eine efindungsgemäßen CBi-Halbleitervorrichtung in einem CBiCMOS-Prozess beschrieben.

Dabei werden nicht mehr als drei bis höchstens fünf zusätzliche lithografische Maskenschritte, im Vergleich zum CMOS-Grundprozess, zur Herstellung der Vorrichtung benötigt, womit insbesondere das Merkmal einer kostengünstigen Bipolarintegration erreicht wird.

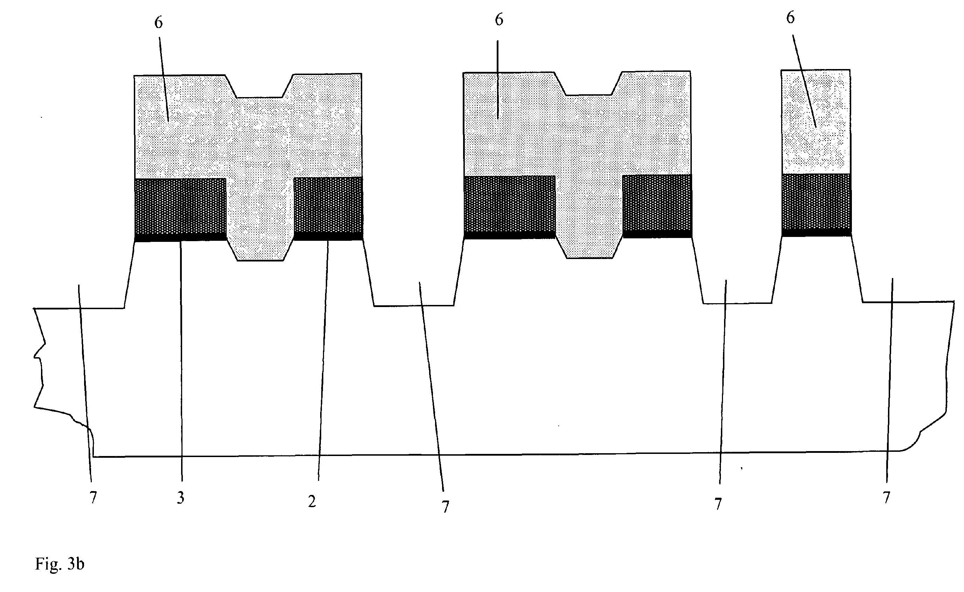

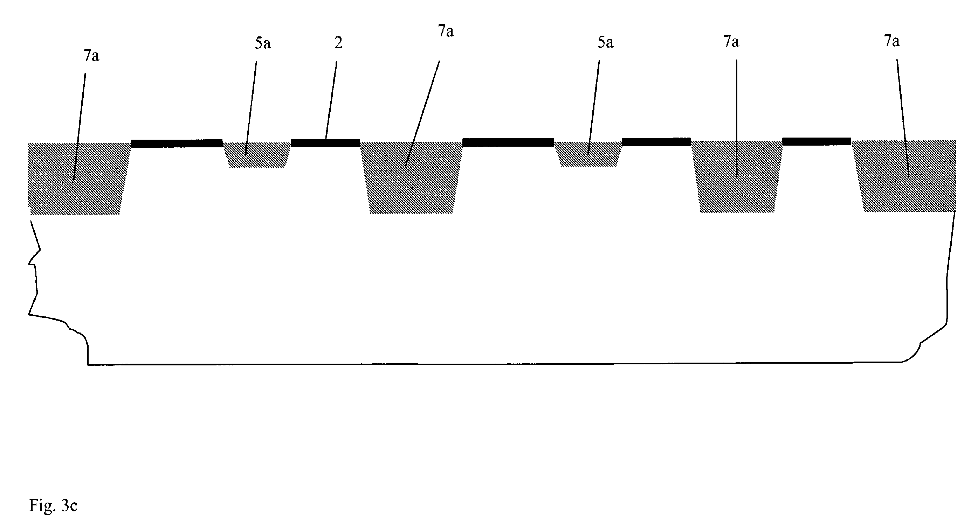

Die Fig. 3a - 3c illustrieren die Herstellung der Isoliergräben der CBi-Halbleitervorrichtung. Eine Schichtkombination aus typischerweise SiO2 (Schicht 2) und Si3N4 (Schicht 3) wird mittels einer ersten, mittels Fotolithografie hergestellten Lackmaske 4, unter Nutzung eines geeigneten RIE (engl.: Reactive Ion Etching)-Schrittes strukturiert. Anschließen erfolgt wieder mittels RIE die Ätzung der flachen Gräben 5 in das Substrat 1 mit einer Tiefe, von der Oberfläche des Substrates 1 gerechnet, von etwa 50-200 nm, optimal von 70-150 nm. Nach Entfernen der Lackmaske 4 und Herstellung einer zweiten Lackmaske 6 erfolgt die Ätzung der tieferen Gräben 7 (Fig. 3b). Diese Prozessfolge ist auch Bestandteil des CMOS-Grundprozesses, so dass nur die Herstellung der Lackmaske 4 als zusätzlicher lithografischer Prozess, im Vergleich zum CMOS-Grundprozess, gelten muss. Nach Entfernung der Lackmaske 6 erfolgen die typischerweise im CMOS-Grundprozess angewandten Schritte zur Grabenverfüllung mit Isolatormaterial (typischerweise SiO₂) und dessen Planarisierung mittels CMP (engl.: Chemical Mechanical Polishing). Anschließend werden die Reste der Schicht 3 mittels nasschemischen Ätzens entfernt. Fig. 3c illustriert den Zustand der CBi-Halbleitervorrichtung an diesem Punkt.

Anschließend erfolgt, gegebenenfalls nach Abätzen der Schicht 2 und Herstellung einer neuen SiO₂-Schicht 2a, die Implantation der Gebiete 8-10 mittels geeigneter Lackmasken. Es werden für die Gebiete 8 - 10 die gleichen Implantationsbedingungen (Spezies, Energie und Dosis) angewandt, wie sie üblicherweise im CMOS-Grundprozess für die Herstellung der Wannen von NMOS- und PMOS-Transistoren sowie von isolierten NMOS-Transistoren zur Anwendung kommen. Auf diese Weise können die Kollektorgebiete der CBi-Halbleitervorrichtung ohne jeglichen Zusatzschritt, verglichen zum CMOS-Grundprozess, hergestellt werden.

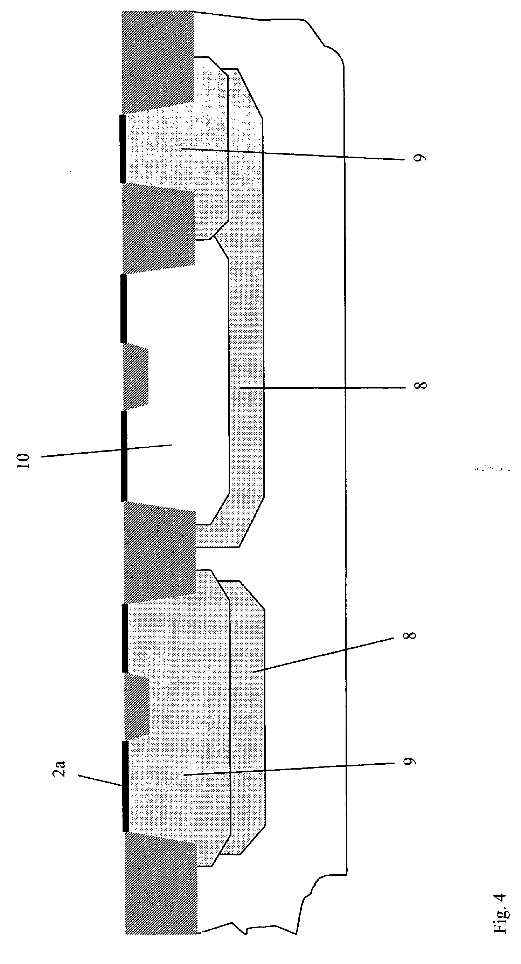

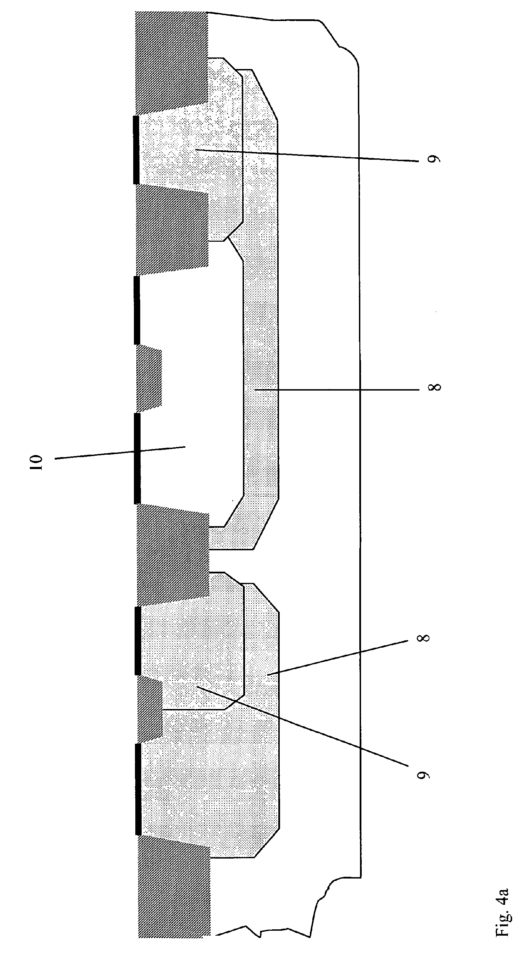

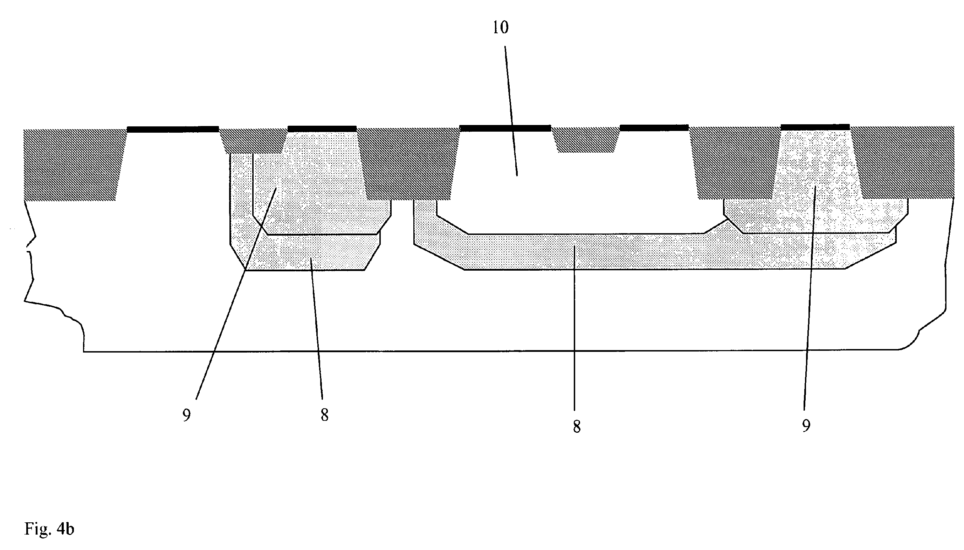

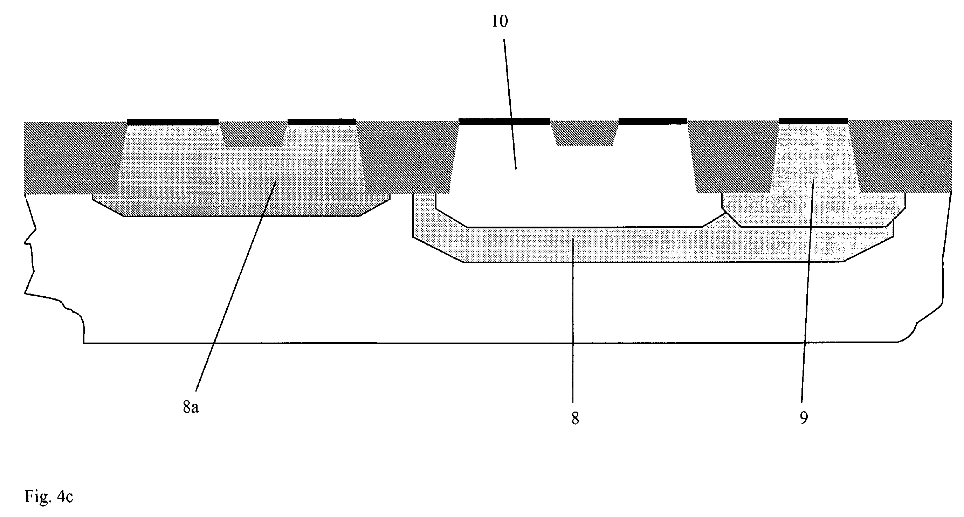

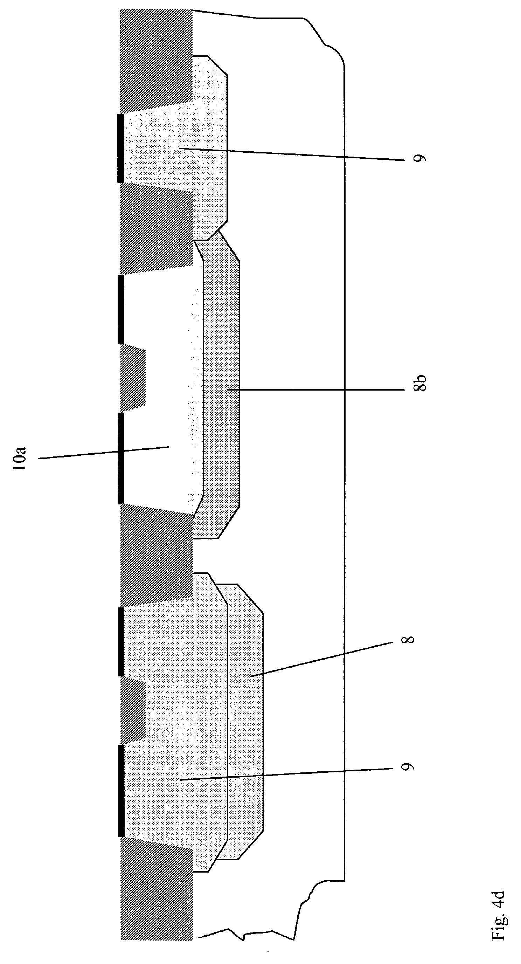

Die Fig. 4a und 4b illustrieren, wie nur durch verändertes Layout der Gebiete 8 und 9 verschiedene Kollektorvarianten für die npn-Transistoren ohne jeglichen Zusatzaufwand, verglichen zur Variante von Fig. 4, ermöglicht werden. Damit können auf einem Chip gleichzeitig verschiedene Typen von npn-Transistoren hergestellt werden, die sich in der Basis-Kollektor-Durchbruchsspannung bei offenem Emitter (BVCBO) und der Kollektor-Emitter-Durchbruchsspannung bei offener Basis (BVCEO) unterscheiden, was die Anwendungsgebiete der CBi-Halbleitervorrichtung wesentlich erweitert.

Fig. 4c zeigt, dass mit einem zusätzlichen lithografischen Schritt, verglichen zum CMOS-Grundprozess, die Herstellung einer weiteren Kollektorvariante 8a möglich ist. Diese ist dann vom CMOS-Grundprozess unabhängig und somit hinsichtlich Implantationsbedingungen frei optimierbar.

Ähnliches liefert ein weiterer lithografischer Zusatzschritt für den pnp-Transistor (Fig. 4d), wobei dieser Schritt es erlaubt, nicht nur die Bedingungen für die Kollektorimplantation für Gebiet 10a als auch die Implantationsbedingungen für das Isolationsgebiet 8b von denen der Wannenherstellung des CMOS-Grundprozess zu entkoppeln und damit frei optimierbar zu machen. Beide Zusatzmasken erlauben es insbesondere, sowohl npn- als auch pnp-Transistoren herzustellen, die verbesserte Hochfrequenzeigenschaften, verglichen mit den Transistoren mit einem Kollektoraufbau nach den Fig. 4, 4a und 4b, aufweisen.

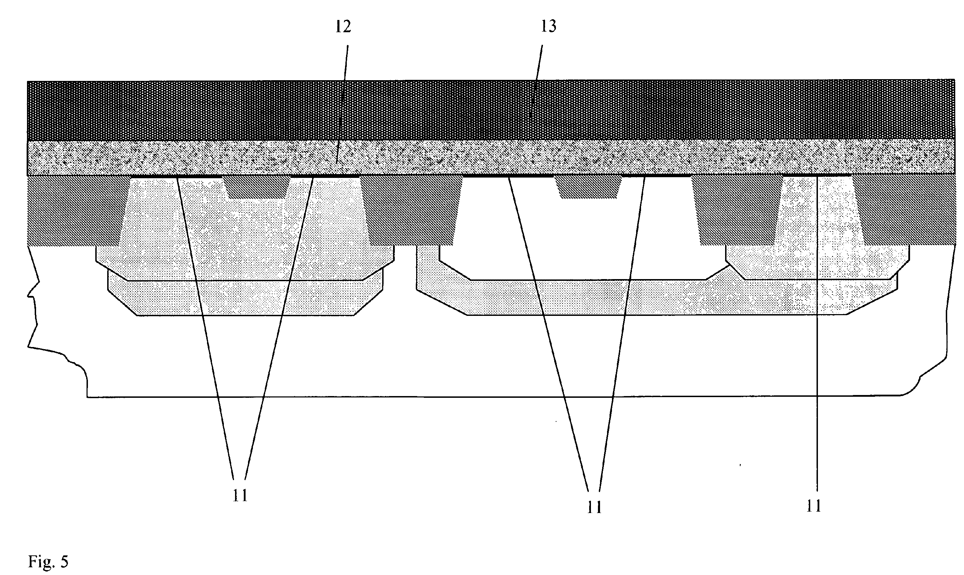

Nach Entfernung der Schichten 2 oder 2a erfolgen im CBiCMOS-Prozess nun die Herstellung des Gate-Isolators 11 und die Abscheidung einer amorphen oder polykristallinen Schicht aus Silizium 12, nachfolgend Polysilizium-Schicht genannt, wie in Fig. 5 dargestellt. Lateral getrennte Teile dieser Schicht bilden am Ende des Herstellungsprozesses sowohl die Gates der MOS-Transistoren aber auch wesentliche Teile der äußeren Basisgebiete der Bipolartransistoren. Oberhalb der Schicht 12 befindet sich eine Isolatorschicht 13, vorzugsweise aus Si₃N₄.

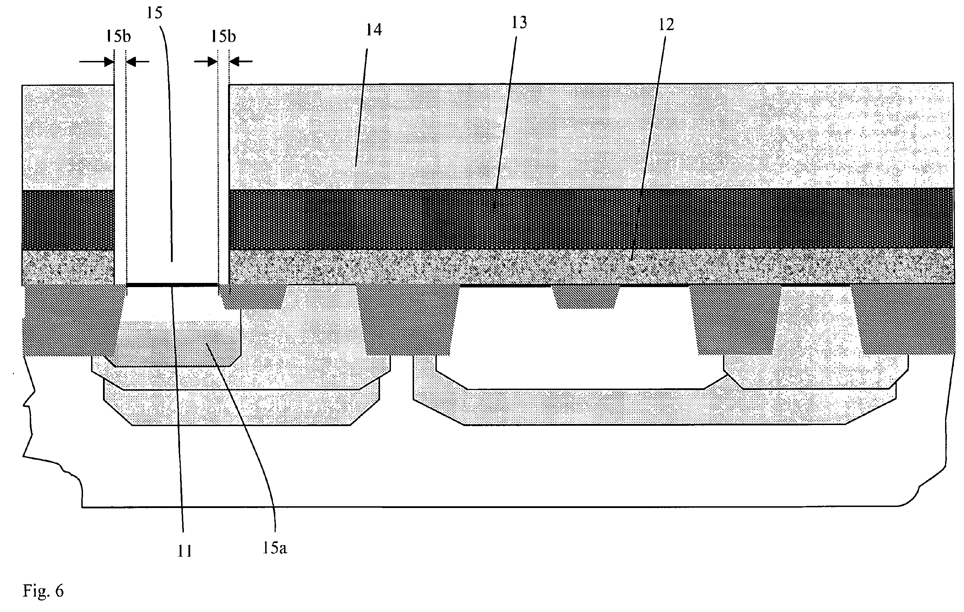

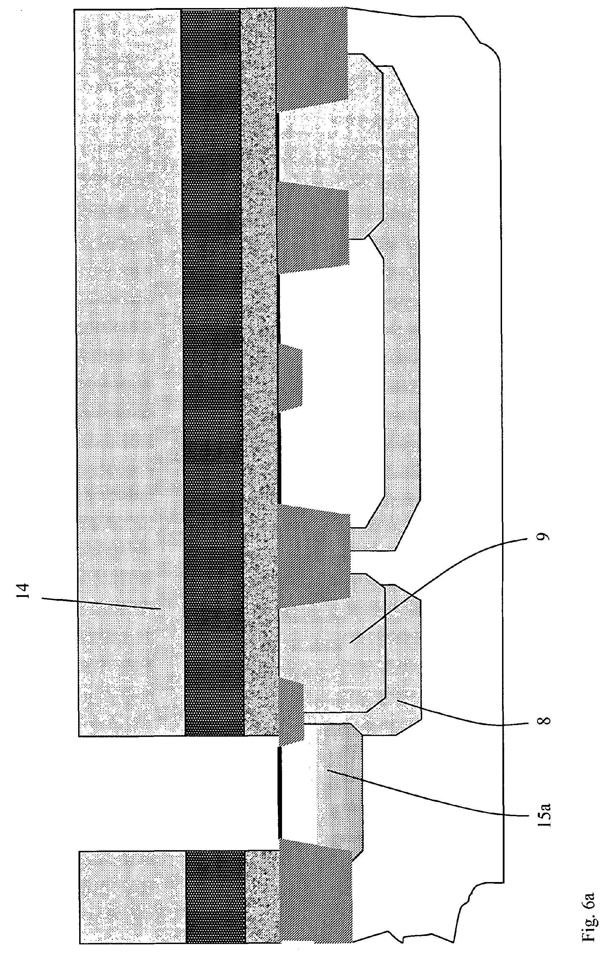

Mit einem weiteren zusätzlichen lithografischen Schritt, verglichen zum CMOS-Grundprozess, wird dann die Lackmaske 14 erzeugt, die der Ätzung (mittels RIE) eines Loches 15 in die Schichten 12 und 13 dient, ohne Schicht 11 wesentlich zu schwächen (Fig. 6). Außerdem können durch diese Loch weitere Implante 15a eingebracht werden, die eine weitere Optimierung der verschiedenen Kollektorvarianten der npn-Transistoren erlauben, wie z.B. in Fig. 6a dargestellt. Ein für die Hochfrequenzeigenschaften wichtiger Abstand ist die Überlappung 15b des Loches 15 über die Isolationsgebiete 7a und 5a (siehe Fig. 6). Diese Überlappung sollte nicht mehr als 50nm betragen.

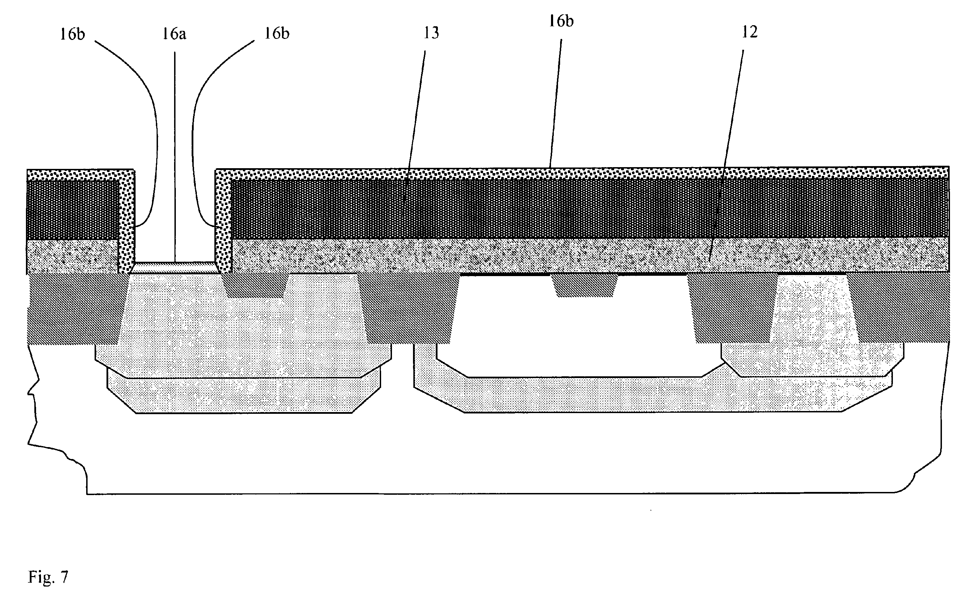

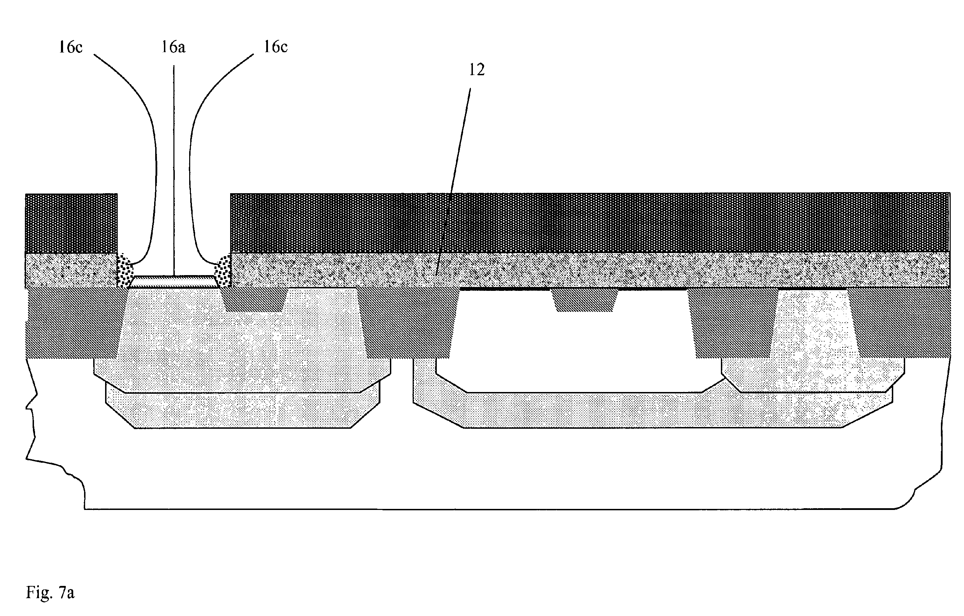

Die Fig. 7-10 illustrieren, wie nun innerhalb des Loches 15 Basis und Emitter der npn-Transistoren hergestellt werden. Zunächst wird nach nasschemischer Entfernung der Schicht 11 ein Epitaxieschritt zur Bildung des einkristallinen Schichtstapels 16a ausgeführt. Typischerweise besteht der Schichtstapel 16a aus einer Folge von Si-, SiGe- und wieder Si-Schichten mit Dicken, Zusammensetzung und Dotierungsprofilen, wie sie üblicherweise zur Herstellung moderner npn-Transistoren für Hochfrequenzanwendungen angewandt werden. Ebenfalls vorteilhaft ist ein Einbau von Kohlenstoff in die SiGe-Schicht und/oder angrenzende Si-Gebiete. Die in Schichtstapel 16a eingebettete SiGe-Schicht ist p-dotiert und bildet die innere Basis des npn-Transistors. In der in Fig. 7 dargestellten Variante wird der Epitaxieschritt zur Herstellung des Schichtstapels 16a unter einem Regime durchgeführt, das gleichzeitig zur Abscheidung einer Schicht 16b an der Seitenwand des Loches 15 und auf der Oberfläche von Schicht 13 führt. Die Schicht 16b unterscheidet sich dabei vom Schichtstapel 16a nicht in der Zusammensetzung und nur wenig oder gar nicht in der Dicke, ist aber polykristallin.

Fig. 7a illustriert eine zweite Variante des Epitaxieschrittes zur Herstellung des Schichtstapels 16a. Bei dieser Variante wird ein Regime gewählt, das gleichzeitig zur Abscheidung einer Schicht 16c führt, wobei sich Schicht 16c nur an den im Loch 15 freiliegenden Wänden der Polysilizium-Schicht 12 bildet. Schicht 16c unterscheidet sich dabei vom Schichtstapel 16a nicht in der Zusammensetzung und nur wenig oder gar nicht in der Dicke, ist aber polykristallin.

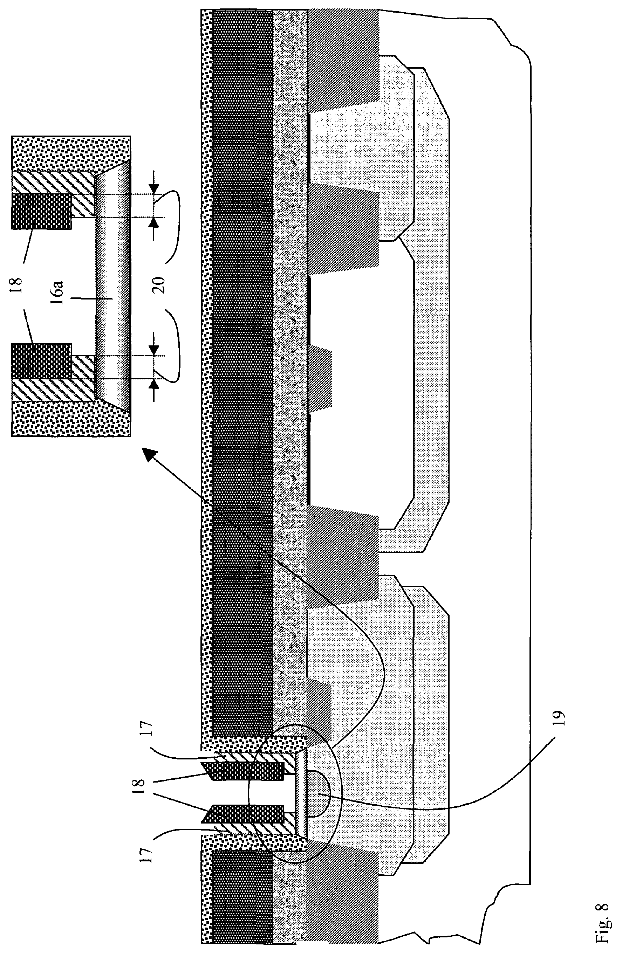

Fig. 8 illustriert die Herstellung der L-förmigen, aus Isolatormaterial, vorzugsweise aus SiO₂ bestehenden Spacer 17. Zunächst wird eine SiO₂-Schicht abgeschieden, gefolgt von einer Si₃N₄-Schicht oder einer Schicht aus n-dotiertem Silizium. Geeignete Dicken dieser Schichten liegen im Bereich von 50-120 nm für SiO₂, 100 - 200 nm für sowohl Si₃N₄ und Silizium. Anschließend erfolgt mittels RIE die Rückätzung der Si₃N₄- oder Silizium-Schichten, wobei der Spacer 18 gebildet wird. Ein weiterer RIE-Schritt dient dann der teilweisen Entfernung der SiO₂-Schicht am Boden des Loches und auf der Oberfläche der Schicht 16b (bzw. der Schicht 13, falls die Epitaxievariante von Fig. 7a angewandt wurde). An dieser Stelle des Herstellungsprozesses kann eine maskenlose Implantation ausgeführt werden, die zur Bildung des n-leitenden Gebietes 19, völlig selbstjustiert zum Emitterfenster, führt. Dieser Aufbau, üblicherweise als selektiv implantierter Kollektor (engl.: SIC) bezeichnet, erlaubt eine weitere Optimierung der Kollektorvarianten der npn-Transistoren. Die finale, in Fig. 8 gezeigte Struktur entsteht nach nasschemischer Entfernung der Reste der SiO₂-Schicht. Durch diese Verfahrensweise wird ein vorteilhaftes Merkmal der CBi-Halbleitervorrichtung gewährleistet, nämlich dass der Betrag 20, mit dem der Emitter das Emitterfenster überragt, auf allen Seiten senkrecht zur Fensterkante stets gleich ist. Das ist in dem vergrößerten Teil von Fig. 8 illustriert.

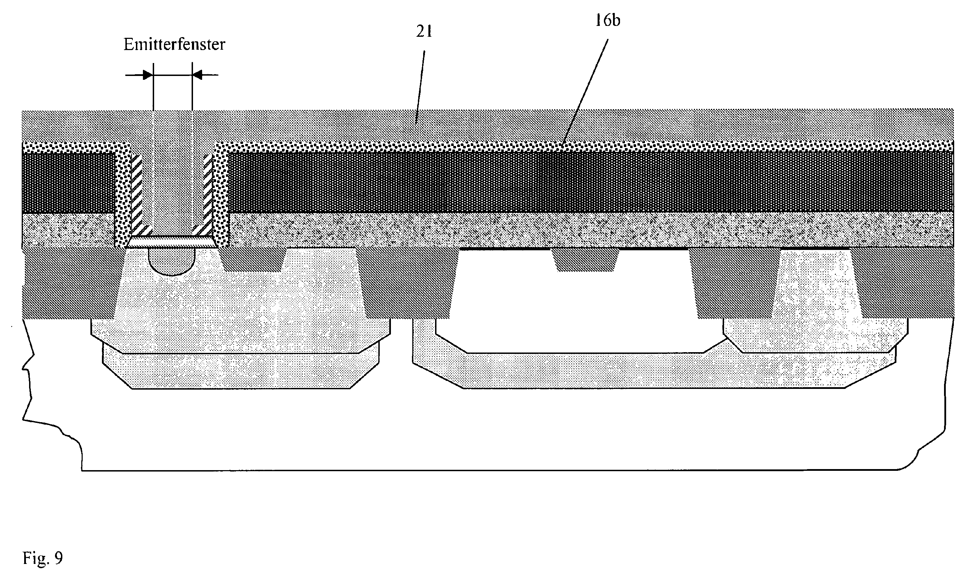

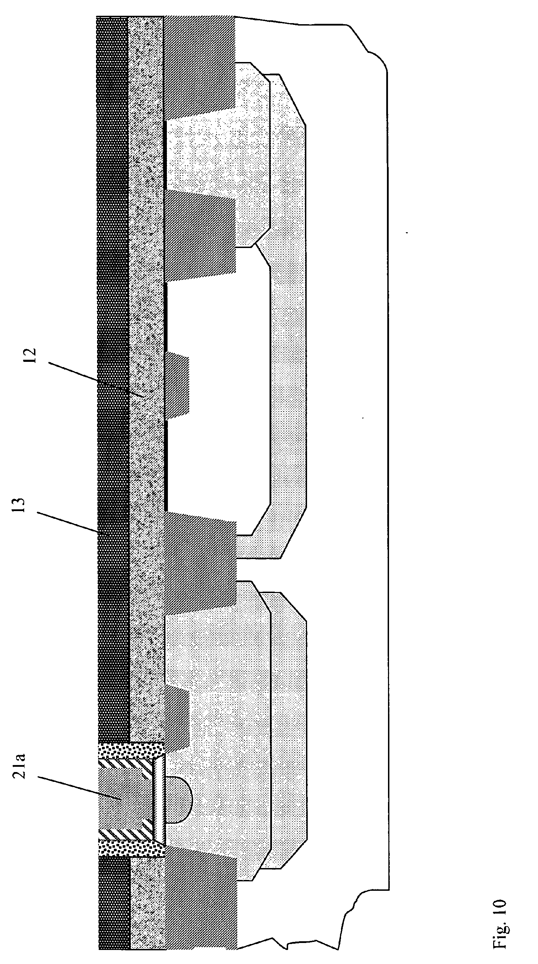

Die Fig. 9 und 10 demonstrieren nun die Herstellung des Emitters der npn-Transistoren. Zunächst erfolgt die Abscheidung einer hoch-n-dotierten Silziumschicht 21 auf der Oberfläche der Schicht 16b (bzw. der Schicht 13, falls die Epitaxievariante von Fig. 7a angewandt wurde) und innerhalb des verspacerten Loches 15. Vor Abscheidung der Schicht 21 kann Spacer 18, falls er aus Si₃N₄ besteht, noch nasschemisch entfernt werden. Anschließend erfolgt eine isotrope vollständige Entfernung der Schichten 21 und 16b von der Oberfläche der Schicht 13 und eine teilweise Entfernung der Schicht 13 selbst. Geeignete Verfahren dafür sind vorzugsweise CMP oder isotropes RIE. Fig. 10 illustriert, dass auf diese Weise ein Emittergebiet 21 a entsteht, das lateral von der Schicht 16b durch den Spacer 17 isoliert ist und das Emitterfenster um den Betrag 20 seitlich überragt, was die spätere Kontaktierung des Emitters im Falle sehr kleiner Emitterfenster erleichtert.

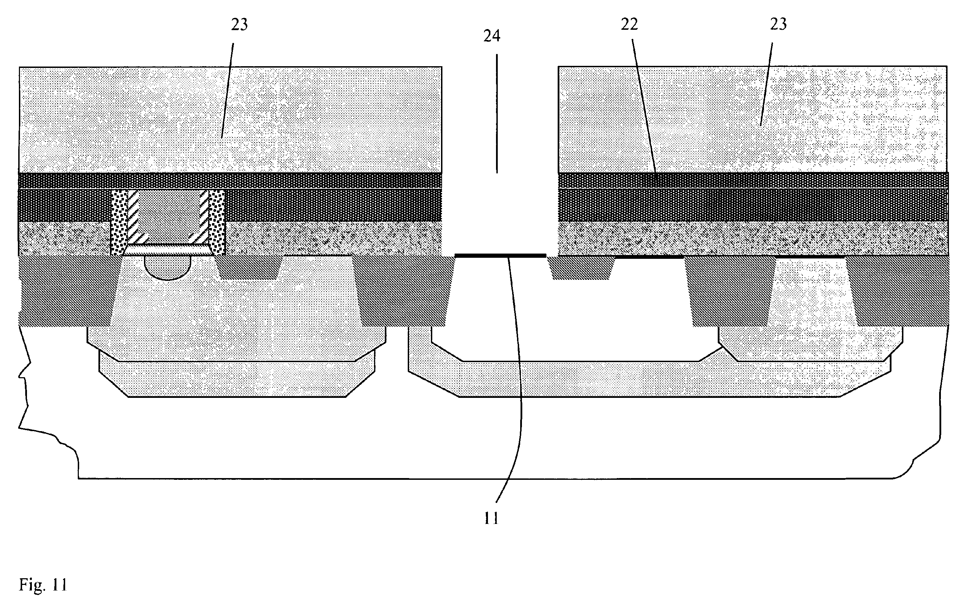

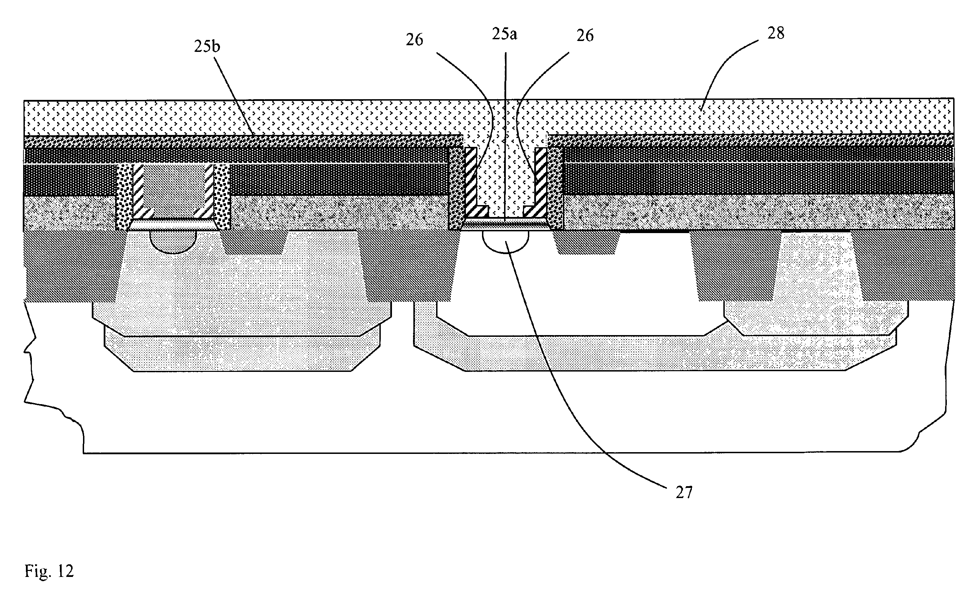

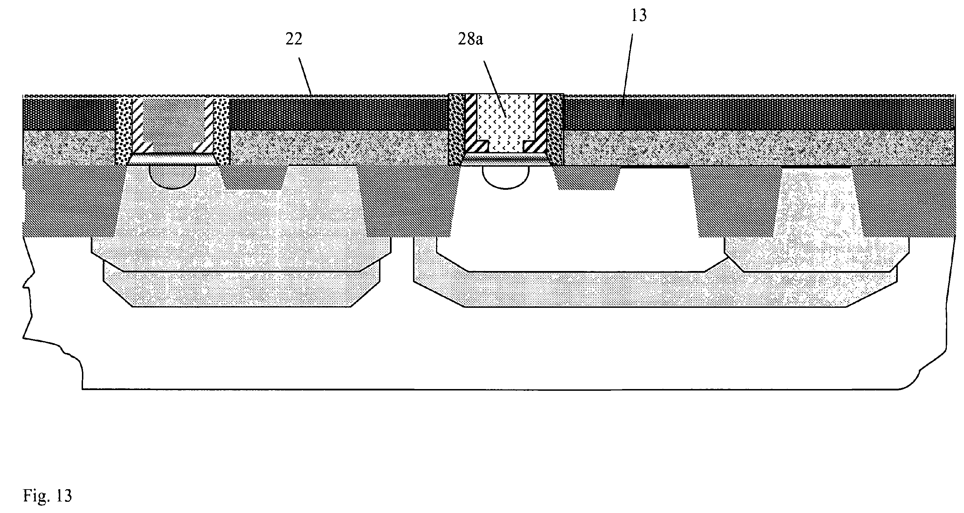

Fig. 11 zeigt die Herstellung eines Loches 24 mittels eines weiteren zusätzlichen lithografischen Schrittes (Lackmaske 23), verglichen zum CMOS-Grundprozess. Vor Bildung der Lackmaske 23 erfolgt noch die Abscheidung einer Isolatorschicht 22 aus SiO₂ oder Si₃N₄, die dem Schutz der schon gebildeten npn-Strukturen während der nachfolgenden Prozessschritte für den pnp-Transistor dient. In Loch 24 werden nun, in völliger Analogie zum npn-Transistor, die innere Basis, deren Anschluss zur äußeren Basis und der Emitter des pnp-Transistors gebildet. Diese Schritte sind in den Fig. 12 und 13 illustriert. Im folgenden werden nur die Analogien und Unterschiede zum npn-Transistor erläutert.

Der Schichtstapel 25a und Schicht 25b des pnp-Transistors entsprechen dem Stapel 16a und Schicht 16b des npn-Transistors. Allerdings enthalten die SiGe-Schichten nun eine n-Dotierung. Eine analoge Variante zu der in Fig. 7a für den npn-Transistor gezeigten, kann auch für den pnp-Transistor ausgeführt werden. Die Spacer 26 entsprechen Spacern 17, können sich aber von den Spacern 17 in den Abmessungen unterscheiden. Der selektive implantierte Kollektor des pnp-Transistors ist das p-leitende Gebiet 27. Für die Emitter-Herstellung wird nun die hoch-p-dotierte Schicht 28 genutzt, deren planarisierte Reste im verspacerten Loch 24 nach CMP (und/oder RIE) den Emitter 28a des pnp-Transistors bilden.

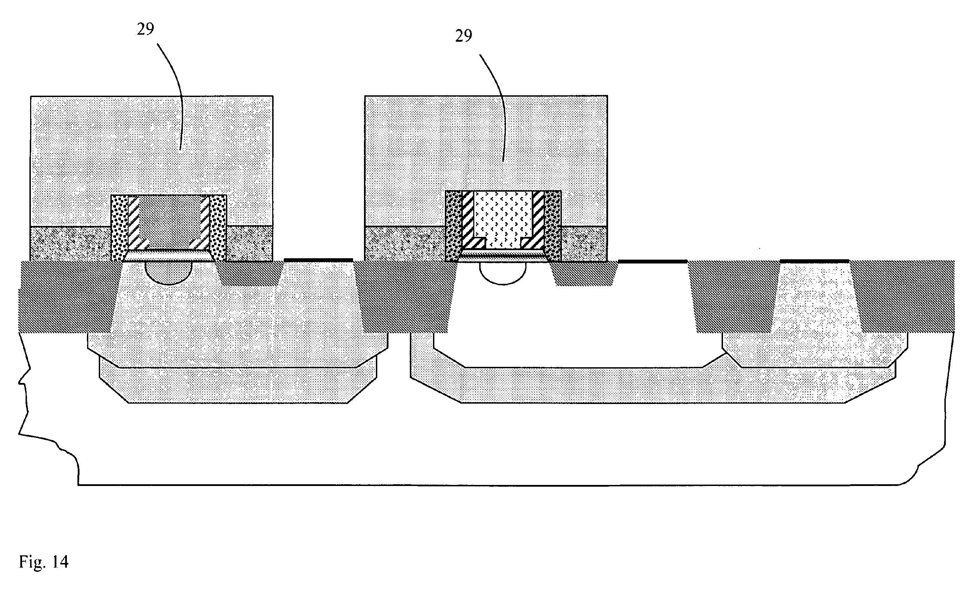

Nach vorzugsweise nasschemischer Entfernung der verbliebenen Schichten 22 und 13 erfolgt nun im CBiCMOS-Prozess die Strukturierung der CMOS-Gates. Dieser Strukturierungsprozess wird auch auf die CBi-Halbleitervorrichtung in der in Fig. 14 dargestellten Weise angewandt, erfordert dadurch keinerlei zusätzlichen Prozessaufwand, insbesondere natürlich auch keinen zusätzlichen lithografischen Schritt für die Herstellung der Lackmaske 29.

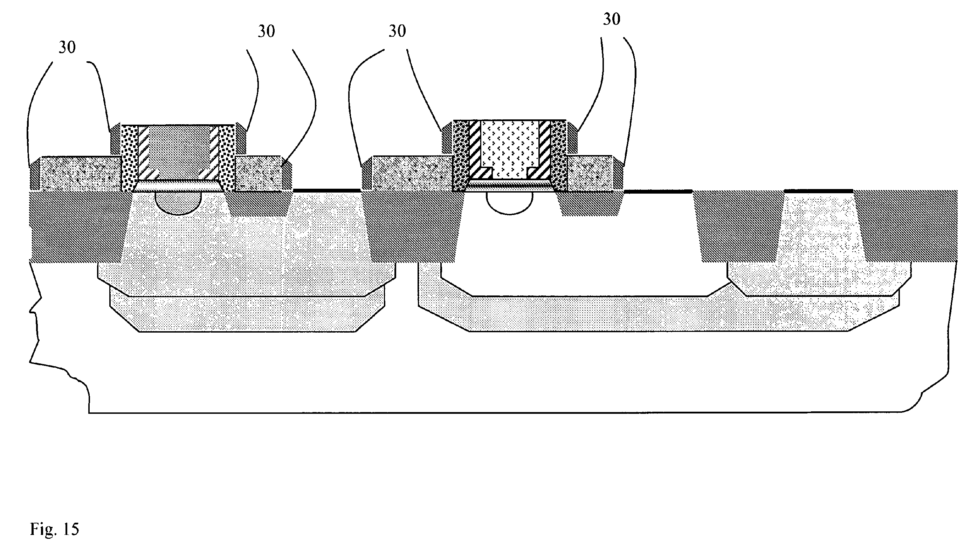

Nach der Gate-Strukturierung werden im CMOS-Grundprozess typischerweise Spacer an den Gate-Seitenwänden gebildet, die typischerweise aus SiO2 oder einer Kombination von SiO₂ und Si₃N₄ bestehen. Diese Spacer 30 bilden sich auch an den Bipolarstrukturen, wie in Fig. 15 illustriert.

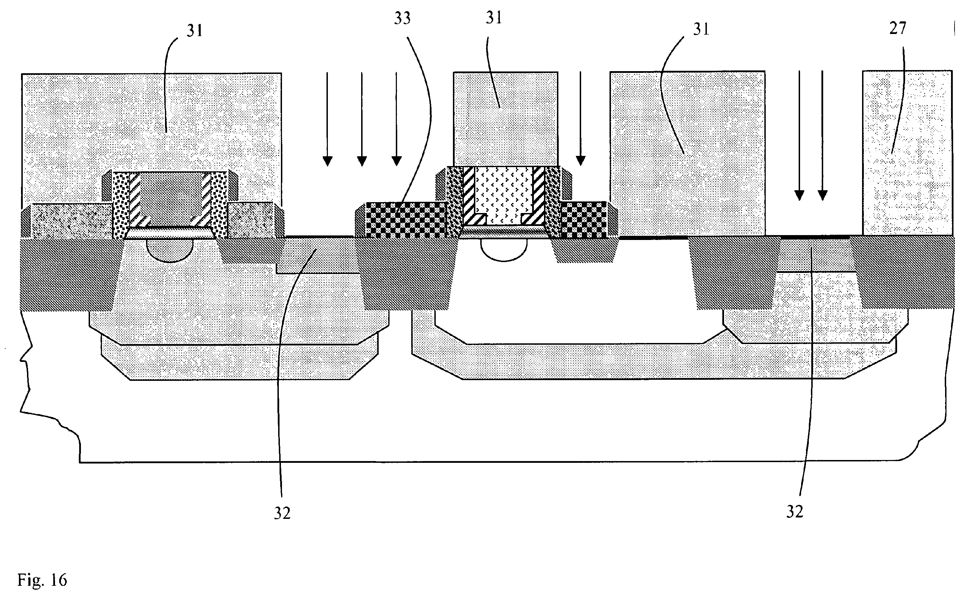

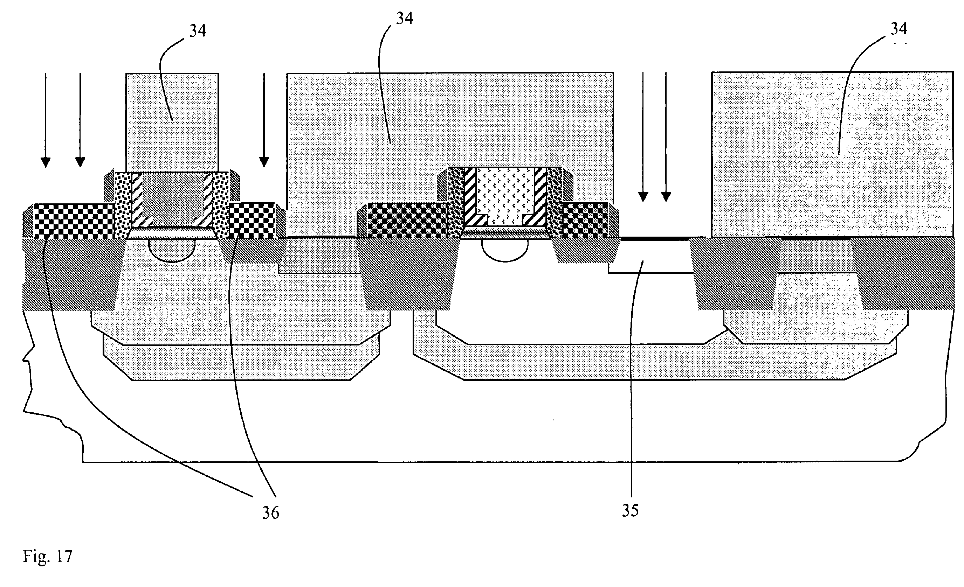

Im CMOS-Grundprozess folgt dann die Implantation der so genannten Source- und Drain-Gebiete der CMOS-Transistoren. Diese Prozessfolge lässt sich nun für eine Komplettierung der CBi-Halbleitervorrichtung ohne jeglichen Zusatzaufwand, verglichen zum CMOS-Grundprozess, ausnutzen, wie in den Fig. 16 und 17 dargestellt.

Durch geeignetes Layout der Maske 31 für die NMOS Source-Drain-Gebiete kann diese auch zur Implantationsdotierung des Kollektorkontaktgebietes 32 der npn-Transistoren, des Kontaktgebietes 32 für die Isolationsschicht der pnp-Transistoren, sowie der Polysilizium-Stücke 33, die Verbindung zur inneren Basis des pnp-Transistors haben, genutzt werden. Genauso kann Maske 34, die der Implantationsdotierung der PMOS Source-Drain-Gebiete dient, auch für die Herstellung des Kollektorkontaktgebietes 35 der pnp-Transistoren und zur Dotierung der Polysiliziumstücke 36, die Verbindung zur inneren Basis des npn-Transistors haben, angewandt werden.

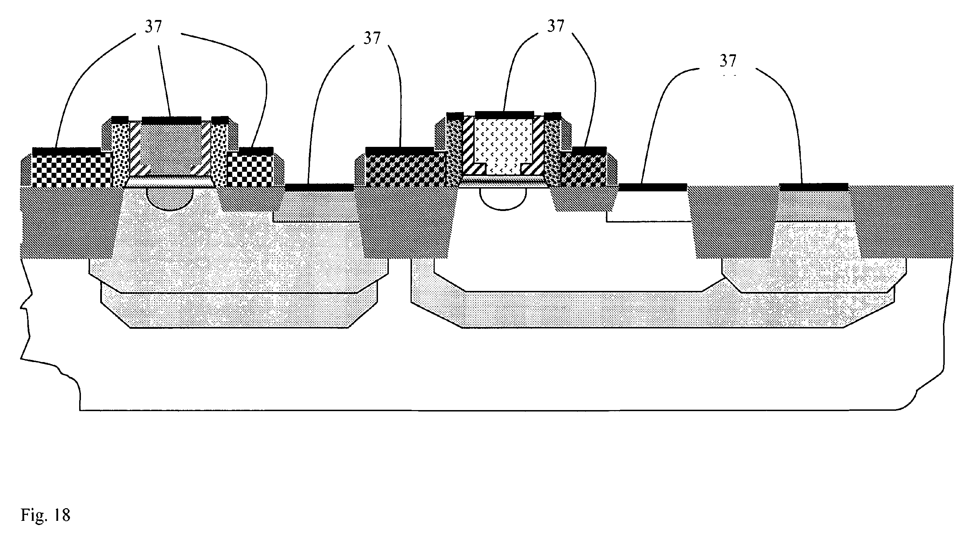

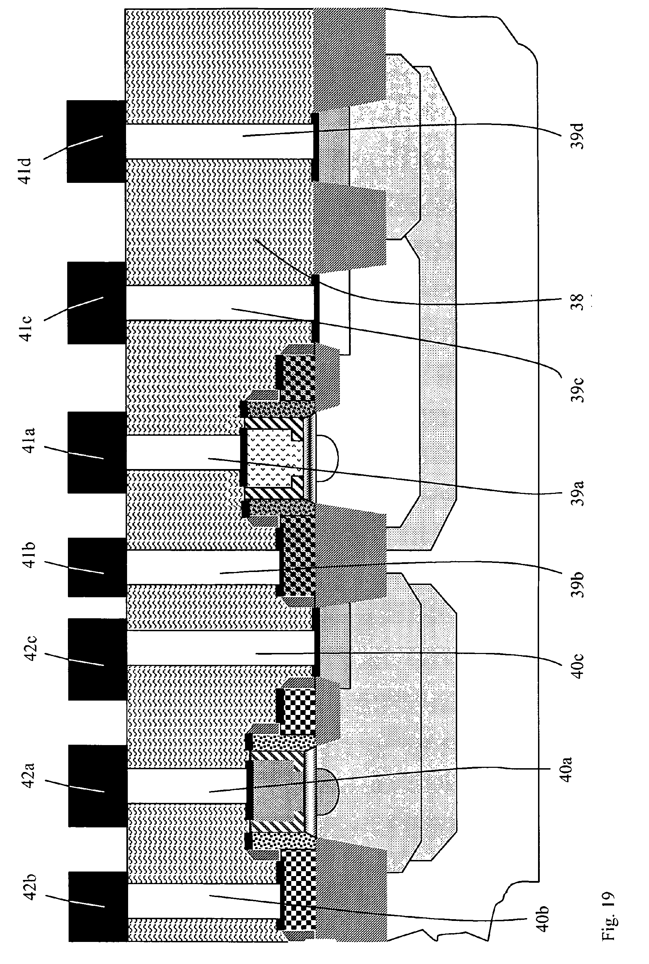

Die Fig. 18 und 19 zeigen noch die Fertigstellung der CBi-Halbleitervorrichtung im CBiCMOS-Prozess bis zur Strukturierung einer ersten Leitbahnebene mittels einer in CMOS-Prozessen üblichen Prozessfolge. Zunächst werden Silizidschichten 37 auf allen nicht mit Isolator bedeckten einkristallinen oder polykristallinen Siliziumgebieten gebildet (z. B. auf Basis von Kobalt oder Titan). Anschließend erfolgt eine Isolatorabscheidung und deren Planarisierung zu Schicht 38. In diese werden Kontaktlöcher geätzt und mit Metall verfüllt (z. B. Wolfram). Nach einem CMP-Schritt entstehen die Kontakte 39a - 39b für den pnp-Transistor und 40a - 40c für den npn-Transistor. Oberhalb dieser Kontakte werden abschließend die Metallstreifen 41a - 41d (pnp) bzw. 42a - 42c (npn) strukturiert, die der Einbindung der CBi-Halbleitervorrichtung in eine integrierte Schaltung dienen. Zusammenfassend wird eine kostengünstige Herstellung der CBi-Halbleitervorrichtung in einem CBiCMOS-Prozess ermöglicht. Es werden nur minimal drei zusätzliche Maskenschritte, verglichen zum CMOS-Grundprozess, für die gleichzeitige Herstellung von verschiedenen npn-Transistoren (unterschiedliche Kollektorvarianten per Layoutvariation (Fig. 4, 4a, 4b)) und einen pnp-Transistor in einem CBiCMOS-Prozess angewandt. Diese drei Maskenschritte sind die Schritte, die zur Herstellung der flachen Gräben 5a und der Löcher 15 und 24 benötigt werden. Verbesserte Hochfrequenzeigenschaften durch vom CMOS-Prozess entkoppelte Optimierung der Kollektor- und Isolations-Implante können durch 2 weitere zusätzliche Maskenschritte, jenen zur Implantation des Gebietes 8a (npn-Transistor, Fig. 4c) und jenen zur Implantation der Gebiete 10a und 8b (pnp-Transistor, Fig. 4d), erreicht werden. Die kostengünstige Bipolarintegration wird durch eine Nutzung folgender Schritte des CMOS-Grundprozesses auch für die CBi-Halbleitervorrichtung zusätzlich gefördert: Nutzung der CMOS-Wannenimplante für die Herstellung der Bipolarkollektoren und deren Isolation; die CMOS-Gate-Schicht wird wesentlicher Teil der äußeren Basis der Bipolartransistoren; die Dotierung wesentlicher Teile der CBi-Halbleitervorrichtung erfolgt unter Nutzung der CMOS Source-Drain-Implante.

Weiterhin erzielt das beschriebene Verfahren eine modulare Integration in einen CMOS-Grundprozess. Das dargestellte Konzept für die Integration der CBi-Halbleitervorrichtung startet im wesentlichen erst nach Abscheidung des CMOS-Gatestapels (Schichten 11 und 12) und endet praktisch schon vor dessen Strukturierung. Da die elektrischen Eigenschaften der CMOS-Transistoren im wesentlichen durch die Implantationsschritte geprägt werden, die nach der Gate-Strukturierung ausgeführt werden (Extensions, Halo, Source-Drain), hat die dargestellte Bipolarintegration kaum Einfluss auf die CMOS-Parameter. Außerdem ist wegen der Verwendung von ausschließlich Niedertemperaturprozessen im Bipolar-Modul (Temperaturen von kleiner 800 °C für alle Bipolar-Schichtabscheidungen) eine Beeinflussung der CMOS-Wannenprofile vernachlässigbar oder so gering, dass sie leicht durch Anpassung der Wannen-Implantationsbedingungen kompensierbar ist.

Die beschriebene CBi-Halbleitervorrichtung weist sehr viele Merkmale auf, die für sehr gute Hochfrequenzeigenschaften förderlich sind, abgesehen der Verwendung von SiGe-Schichten und deren Verbesserung durch Kohlenstoffeinbau:
(a) Die Verwendung des flachen Isolationsgrabens 5a (anstelle des Standardgrabens 7a) zwischen aktivem Transistorgebiet und Kollektorkontaktgebiet erlaubt es, niedrige Kollektorwiderstände gemeinsam mit niedriger Basis-Kollektor-Kapazität zu erreichen. Das ist ein entscheidender Fortschritt zur Kostenreduzierung nicht nur im Zusammenhang mit der hier gezeigten Bipotarintegration, die nur implantierte Kollektoren nutzt und auf die Verwendung der viel aufwendigeren Konstruktion mit epitaktisch vergrabenen, niederohmigen Subkollektoren verzichtet.
(b) Durch die dargestellte Spacer-Technologie zur Isolation von Emitter und äußerer Basis ist letztere selbstjustiert zum Emitter, was sich günstig auf die Realisierung niedriger Basiswiderstände auswirkt.
(c) Der Abstand zwischen aktivem Transistorgebiet und Basis-Silizid ist gering, was ebenfalls günstig für niedrige Basiswiderstände ist.

## Patentansprüche

1. Komplementäre Bipolar-Halbleitervorrichtung, nachfolgend CBi-Halbleitervorrichtung, mit
- einem Substrat eines ersten Leitfähigkeitstyps,
- aktiven Bipolartransistorgebieten im Substrat, in denen Basis, Emitter und Kollektor vertikaler Bipolartransistoren angeordnet sind,
- vertikalen npn-Bipolartransistoren mit epitaxialer Basis in einer ersten Teilanzahl der aktiven Bipolartransistorgebiete,
- vertikalen pnp-Bipolartransistoren mit epitaxialer Basis in einer zweiten Teilanzahl der aktiven Bipolartransistorgebiete,
- Kollektorkontaktgebieten, die jeweils an ein aktives Bipolartransistorgebiet angrenzend angeordnet sind, sowie
- flachen, grabenförmigen, annähernd bündig mit einer Substratoberfläche abschließenden Feldisolationsgebieten, welche die aktiven Bipolartransistorgebiete und die Kollektorkontaktgebiete jeweils lateral begrenzen,
**dadurch gekennzeichnet, dass** zwischen der ersten oder der zweiten oder sowohl der ersten als auch der zweiten Teilanzahl aktiver Bipolartransistorgebiete (19, 27) einerseits und den angrenzenden Kollektorkontaktgebieten (32, 35) andererseits jeweils ein flaches Feldisolationsgebiet (5a) eines ersten Typs mit einer ersten Tiefenausdehnung zwischen 50 nm und 200 nm in Richtung des Substratinneren angeordnet ist, und dass flache Feldisolationsgebiete (7a) eines zweiten Typs mit einer zweiten, größeren Tiefenausdehnung zwischen 300 nm und 600 nm als die erste Tiefenausdehnung die aktiven Bipolartransistorgebiete (19, 27) und die Kollektorkontaktgebiete (32, 35) im Querschnitt gesehen an ihren von einander abgewandten Seiten begrenzen.

2. CBi-Halbleitervorrichtung nach Anspruch 1, bei denen die pnp-Bipolartransistoren und die npn-Bipolartransistoren äußere Basisgebiete (33, 36), aufweisen die sich nur in ihrem Leitfähigkeitstyp, nicht aber, abgesehen von ihrer Leitfähigkeitsdotierung, in ihrer Materialzusammensetzung und Dicke unterscheiden.

3. CBi-Halbleitervorrichtung nach Anspruch 2, die zusätzlich CMOS-Transistoren enthält, und bei der die äußeren Basisgebiete (33, 36) aus derselben Materialschicht gebildet sind, aus welcher Gates der CMOS-Transistoren gebildet sind.

4. CBi-Halbleitervorrichtung nach einem der vorstehenden Ansprüche, bei der die npn- und pnp-Bipolartransistoren einen in einem Emitterfenster ausgebildeten Emitter aufweisen, der zusätzlich Emittergebiete aufweist, die lateral und in Richtungen senkrecht zu einer Kante des Emitterfensters das Emitterfenster um einen Längenbetrag überragen.

5. CBi-Halbleitervorrichtung nach Anspruch 4, bei der der Längenbetrag, um den die Emittergebiete das Emitterfenster überragen, bezüglich jedem Punkt der Fensterkante gleich ist.

6. CBi-Halbleitervorrichtung nach Anspruch 5, bei der die Emittergebiete das Emitterfenster bei den npn-Bipolartransistoren um einen anderen Längenbetrag überragen als bei den pnp-Bipolartransistoren.

7. CBi-Halbleitervorrichtung nach einem der Ansprüche 4 bis 6, bei der der Längenbetrag bei den npn-Bipolartransistoren und bei den pnp-Bipolartransistoren einen jeweiligen Wert zwischen 30 und 80nm hat.

8. CBi-Halbleitervorrichtung nach einem der vorstehenden Ansprüche, bei der ausschließlich bei demjenigen Bipolartransistortyp, bei dem der Leitfähigkeitstyp des Substrates mit dem des Kollektorgebietes übereinstimmt, zwischen Kollektor und Substrat ein lsolationsdotierungsgebiet angeordnet ist, welches ausgebildet ist, Kollektor und Substrat von einander elektrisch zu isolieren.

9. CBi-Halbleitervorrichtung nach einem der vorstehenden Ansprüche, bei der die flachen Feldisolationsgebiete des ersten Typs in Richtung des Substratinneren eine Tiefenausdehnung zwischen 70 und 150 nm haben.

10. Verfahren zur Herstellung einer CBi-Halbleitervorrichtung, mit den Schritten:
- Bereitstellen eines Substrat eines ersten Leitfähigkeitstyps;
- Herstellen aktiver Bipolartransistorgebiete im Substrat zum späteren Herstellen von Basis, Emitter und Kollektor vertikaler Bipolartransistoren darin;
- Herstellen von Kollektorkontaktgebieten, die jeweils an ein aktives Bipolartransistorgebiet angrenzend angeordnet werden;
- Herstellen flacher, grabenförmiger Feldisolationsgebiete annähernd Bündig mit einer Substratoberfläche, welche die aktiven Bipolartransistorgebiete und die Kollektorkontaktgebiete jeweils lateral begrenzen;
- Herstellen vertikaler npn-Bipolartransistoren mit epitaxialer Basis in einer ersten Teilanzahl der aktiven Bipolartransistorgebiete; und
- Herstellen vertikaler pnp-Bipolartransistoren mit epitaxialer Basis in einer zweiten Teilanzahl der aktiven Bipolartransistorgebiete;
**dadurch gekennzeichnet, dass**
- das Herstellen der flachen Feldisolationsgebiete das Herstellen jeweils eines flachen Feldisolationsgebietes (5a) eines ersten Typs mit einer ersten Tiefenausdehnung zwischen 50 nm und 200 nm in Richtung des Substratinneren zwischen der ersten oder der zweiten oder sowohl der ersten als auch der zweiten Teilanzahl aktiver Bipolartransistorgebiete (19, 27) einerseits und den angrenzenden Kollektorkontaktgebieten (32, 35) andererseits umfasst, und dass
- das Herstellen der flachen Feldisolationsgebiete (7a) das Herstellen flacher Feldisolationsgebiete eines zweiten Typs mit einer zweiten, größeren Tiefenausdehnung zwischen 300 nm und 600 nm als die erste Tiefenausdehnung umfasst, die die aktiven Bipolartransistorgebiete (19, 27) und die Kollektorkontaktgebiete (32, 35) im Querschnitt gesehen an ihren von einander abgewandten Seiten begrenzen.

11. Verfahren nach Anspruch 10, bei dem das Herstellen der pnp-Bipolartransistoren und der npn-Bipolartransistoren das Herstellen äußerer Basisgebiete umfasst, die sich nur in ihrem Leitfähigkeitstyp, nicht aber, abgesehen von ihrer Leitfähigkeitsdotierung, in ihrer Materialzusammensetzung und Dicke unterscheiden.

12. Verfahren nach Anspruch 11, bei dem zusätzlich CMOS-Transistoren hergestellt werden, und bei dem die äußeren Basisgebiete (33, 36) aus derselben Materialschicht gebildet werden, aus welcher Gates der CMOS-Transistoren gebildet werden.

13. Verfahren nach einem der Ansprüche 10 bis 12, bei dem ausschließlich bei demjenigen Bipolartransistortyp, bei dem der Leitfähigkeitstyp des Substrates mit dem des Kollektorgebietes übereinstimmt, zwischen Kollektor und Substrat ein Isolationsdotierungsgebiet hergestellt wird, welches ausgebildet ist, Kollektor und Substrat von einander elektrisch zu isolieren.

14. Verfahren nach einem der Ansprüche 10 bis 13, bei der die flachen Feldisolationsgebiete des ersten Typs in Richtung des Substratinneren eine Tiefenausdehnung zwischen 70 und 150 nm haben.

## Claims

1. Complementary bipolar semiconductor device, hereinafter referred to as a CBi semiconductor device, having
- a substrate of a first conductivity type,
- active bipolar transistor regions in the substrate in which the base, emitter and collector of vertical bipolar transistors are arranged,
- vertical npn bipolar transistors with an epitaxial base in a first partial number of the active bipolar transistor regions,
- vertical pnp bipolar transistors with an epitaxial base in a second partial number of the active bipolar transistor regions,
- collector contact regions which are each arranged adjacent to an active bipolar transistor region, and
- flat, trench-shaped field insulation regions arranged approximately flush with a substrate surface, which laterally delimit the active bipolar transistor regions and the collector contact regions,
**characterised in that** between the first or second or both the first and the second partial number of active bipolar transistor regions (19, 27) on the one hand and the adjacent collector contact regions (32, 35) on the other hand is arranged, in each case, a flat field insulation region (5a) of a first type with a first depthwise dimension of between 50 nm and 200 nm in the direction of the inside of the substrate, and **in that** flat field insulation regions (7a) of a second type with a second depthwise dimension of between 300 nm and 600 nm which is greater than the first depthwise dimension delimit the active bipolar transistor regions (19, 27) and the collector contact regions (32, 35), viewed in cross-section, on their sides remote from one another.

2. CBi semiconductor device according to claim 1, wherein the pnp bipolar transistors and the npn bipolar transistors have outer base regions (33, 36) which differ only in their type of conductivity but not in their material composition (other than their conductivity doping) and thickness.

3. CBi semiconductor device according to claim 2, which additionally contains CMOS transistors, and wherein the outer base regions (33, 36) are formed from the same layer of material from which gates of the CMOS transistors are formed.

4. CBi semiconductor device according to one of the preceding claims, wherein the npn and pnp bipolar transistors comprise an emitter formed in an emitter window, said emitter additionally comprising emitter regions that project by a lengthwise amount beyond the emitter window laterally and in directions perpendicular to an edge of the emitter window.

5. CBi semiconductor device according to claim 4, wherein the lengthwise amount by which the emitter regions project beyond the emitter window is the same with respect to every point on the edge of the window.

6. CBi semiconductor device according to claim 5, wherein the emitter regions project beyond the emitter window in the npn-bipolar transistors by a different lengthwise amount than in the pnp bipolar transistors.

7. CBi semiconductor device according to one of claims 4 to 6, wherein the lengthwise amount in the npn bipolar transistors and in the pnp bipolar transistors has a value of between 30 and 80 nm.

8. CBi semiconductor device according to one of the preceding claims, wherein an insulation doping region is arranged between the collector and substrate only in the type of bipolar transistor in which the conductivity type of the substrate is the same as that of the collector region, said insulation doping region being configured so as to insulate the collector and substrate from each other electrically.

9. CBi semiconductor device according to one of the preceding claims, wherein the flat field insulation regions of the first type have a depthwise dimension of between 70 and 150 nm in the direction of the interior of the substrate.

10. Method of producing a CBi semiconductor device, comprising the steps of:
- providing a substrate of a first conductivity type;
- producing active bipolar transistor regions in the substrate for the later production of base, emitter and collector of vertical bipolar transistors therein;
- producing collector contact regions, each of which is arranged adjacent to an active bipolar transistor region;
- producing flat, trench-shaped field insulation regions substantially flush with a substrate surface, which laterally delimit the active bipolar transistor regions and the collector contact regions in each case;
- producing vertical npn bipolar transistors with an epitaxial base in a first partial number of the active bipolar transistor regions; and
- producing vertical pnp bipolar transistors with an epitaxial base in a second partial number of the active bipolar transistor regions;
**characterised in that**
- the production of the flat field insulation regions encompasses the production of, in each case, a flat field insulation region (5a) of a first type with a first depthwise dimension of between 50 nm and 200 nm in the direction of the substrate interior between the first or second or both the first and the second partial number of active bipolar transistor regions (19, 27) on the one hand and the adjacent collector contact regions (32, 35) on the other hand, and **in that**
- the production of the flat field insulation regions (7a) encompasses the production of flat field insulation regions of a second type with a second depthwise dimension of between 300 nm and 600 nm that is greater than the first depthwise dimension, which delimit the active bipolar transistor regions (19, 27) and the collector contact regions (32, 35), viewed in cross-section, at their sides remote from one another.

11. Method according to claim 10, wherein the production of the pnp bipolar transistors and the npn bipolar transistors encompasses the production of external base regions which differ only in their type of conductivity, but not in their material composition (apart from their conductivity doping) and thickness.

12. Method according to claim 11, wherein additionally CMOS transistors are produced, and wherein the outer base regions (33, 36) are formed from the same layer of material from which gates of the CMOS transistors are formed.

13. Method according to one of claims 10 to 12, wherein an insulation doping region is arranged between the collector and substrate only in the type of bipolar transistor in which the conductivity type of the substrate is the same as that of the collector region, said insulation doping region being configured so as to insulate the collector and substrate from each other electrically.

14. Method according to one of claims 10 to 13, wherein the flat field insulation regions of the first type have a depthwise dimension of between 70 and 150 nm in the direction of the interior of the substrate.

## Revendications

1. Dispositif semi-conducteur bipolaire complémentaire, appelé ci-après dispositif semi-conducteur CBi, comportant :
- un substrat d'un premier type de conductivité,
- des zones actives à transistor bipolaire dans le substrat, dans lesquelles sont disposés une base, un émetteur et un collecteur de transistors bipolaires verticaux,
- des transistors bipolaires NPN verticaux ayant une base épitaxiale dans une première quantité partielle des zones actives à transistor bipolaire,
- des transistors bipolaires PNP verticaux ayant une base épitaxiale dans une deuxième quantité partielle des zones actives à transistor bipolaire,
- des zones de contact de collecteur qui sont disposées respectivement de manière adjacente à une zone active à transistor bipolaire, ainsi que
- des zones d'isolement de champ plates, en forme de fossé, affleurant pratiquement une surface du substrat, qui limitent chacune latéralement les zones actives à transistor bipolaire et les zones de contact de collecteur,
**caractérisé en ce qu'**une zone d'isolation de champ plat (5a) d'un premier type ayant une première étendue en profondeur en direction de l'intérieur du substrat entre 50 nm et 200 nm, est disposée respectivement entre la première ou la deuxième ou aussi bien la première que la deuxième quantité partielle de zones actives à transistor bipolaire (19, 27) d'une part et de zones de contact de collecteur (32, 35) adjacentes d'autre part,
et **en ce que** des zones d'isolement de champ plates (7a) d'un deuxième type ayant une deuxième étendue en profondeur plus grande entre 300 nm et 600 nm que la première étendue en profondeur délimitent les zones actives à transistor bipolaire (19, 27) et les zones de contact de collecteur (32, 35) sur leurs côtés opposés en vue en coupe transversale.

2. Dispositif semi-conducteur CBi selon la revendication 1, dans lequel les transistors bipolaires PNP et les transistors bipolaires NPN présentent des zones de base externes (33, 36) qui se différencient uniquement par leur type de conductivité, mais pas par leur épaisseur ni par leur composition matérielle, à l'exception de leur dopage de conductivité.

3. Dispositif semi-conducteur CBi selon la revendication 2, qui contient en plus des transistors CMOS et dans lequel des zones de base externes (33, 36) sont formées de la même couche matérielle dont sont formées les grilles des transistors CMOS.

4. Dispositif semi-conducteur CBi selon l'une quelconque des revendications précédentes, dans lequel les transistors bipolaires PNP et NPN comportent un émetteur qui est formé dans une fenêtre d'émetteur et qui comporte en plus des zones d'émetteur qui dépassent d'une certaine longueur de la fenêtre d'émetteur latéralement et dans des directions perpendiculaires à un bord de la fenêtre d'émetteur.

5. Dispositif semi-conducteur CBi selon la revendication 4, dans lequel ladite longueur, de laquelle les zones d'émetteur dépassent de la fenêtre d'émetteur, est identique en ce qui concerne chaque point du bord de la fenêtre.

6. Dispositif semi-conducteur CBi selon la revendication 5, dans lequel les zones d'émetteur pour les transistors bipolaires NPN dépassent de la fenêtre d'émetteur d'une autre longueur que celle pour les transistors bipolaires PNP.

7. Dispositif semi-conducteur CBi selon l'une quelconque des revendications 4 à 6, dans lequel la longueur pour les transistors bipolaires NPN et pour les transistors bipolaires PNP a une valeur respective entre 30 et 80 nm.

8. Dispositif semi-conducteur CBi selon l'une quelconque des revendications précédentes, dans lequel exclusivement pour le type de transistor bipolaire pour lequel le type de conductivité du substrat correspond avec celui de la zone de collecteur, est disposée entre le collecteur et le substrat une zone de dopage d'isolation qui est formée pour isoler électriquement l'un de l'autre le collecteur et le substrat.

9. Dispositif semi-conducteur CBi selon l'une quelconque des revendications précédentes, dans lequel les zones plates d'isolement de champ du premier type ont une étendue en profondeur en direction de l'intérieur du substrat entre 70 et 150 nm.

10. Procédé de fabrication d'un dispositif semi-conducteur CBi, comportant les étapes :
- préparation d'un substrat d'un premier type de conductivité ;
- réalisation de zones actives à transistor bipolaire dans le substrat en vue d'y réaliser ultérieurement des bases, émetteurs et collecteurs de transistors bipolaires verticaux ;
- réalisation de zones de contact de collecteur qui sont disposées respectivement adjacentes à une zone active à transistor bipolaire ;
- réalisation de zones d'isolement de champ plates, en forme de fossé, affleurant pratiquement une surface du substrat, lesquelles zones délimitant chacune latéralement les zones actives à transistor bipolaire et les zones de contact de collecteur ;
- réalisation de transistors bipolaires NPN verticaux ayant une base épitaxiale dans une première quantité partielle des zones actives à transistor bipolaire ; et
- réalisation de transistors bipolaires PNP verticaux ayant une base épitaxiale dans une deuxième quantité partielle des zones actives à transistor bipolaire ;
**caractérisé en ce que**
- la réalisation des zones d'isolement de champ plates comporte la réalisation respectivement d'une zone d'isolement de champ plate (5a) d'un premier type ayant une première étendue en profondeur entre 50 nm et 200 nm en direction de l'intérieur du substrat entre la première ou la deuxième ou aussi bien la première que la deuxième quantité partielle de zones actives à transistor bipolaire (19, 27) d'une part et de zones de contact de collecteur limitrophes (32, 35) d'autre part, et **en ce que**
- la réalisation des zones plates d'isolement de champ (7a) comporte la réalisation de zones plates d'isolement de champ d'un deuxième type ayant une deuxième étendue en profondeur plus grande entre 300 nm et 600 nm que la première étendue en profondeur, qui délimitent les zones actives à transistor bipolaire (19, 27) et les zones de contact de collecteur (32, 35) sur leurs côtés opposés en vue en coupe transversale.

11. Procédé selon la revendication 10, dans lequel la réalisation des transistors bipolaires PNP et des transistors bipolaires NPN comporte la réalisation de zones de base externes, qui se différencient uniquement par leur type de conductivité, mais pas par leur épaisseur ni composition matérielle, à l'exception de leur dopage de conductivité.

12. Procédé selon la revendication 11, dans lequel sont réalisés en plus des transistors CMOS, et dans lequel les zones de base externes (33, 36) sont formées de la même couche matérielle dont sont formées les grilles de transistors CMOS.

13. Procédé selon l'une des revendications 10 à 12, dans lequel exclusivement pour le type de transistor bipolaire, pour lequel le type de conductivité du substrat correspond à celui de la zone de collecteur, est réalisée entre collecteur et substrat une zone de dopage d'isolation qui est formée pour isoler électriquement l'un de l'autre collecteur et substrat.

14. Procédé selon l'une des revendications 10 à 13, dans lequel les zones plates d'isolement de champ du premier type ont une étendue en profondeur entre 70 et 150 nm en direction de l'intérieur du substrat.
